# EUROPEAN PATENT APPLICATION

(11) **EP 1 237 342 A2**
(43) Date of publication of application: **04.09.2002**
(21) Application number: 02251432.7
(22) Date of filing: 28.02.2002
(51) Int. Cl.: H04L 27/26

(54) **Mutlicarrier modulator**

(30) Priority: 01.03.2001 JP 2001056931; 23.03.2001 JP 2001085907; 23.03.2001 JP 2001085915
(71) Applicant: ALPS ELECTRIC CO., LTD., Ota-ku Tokyo (JP)
(72) Inventor: Otaki, Yukio, c/o Alps Electric Co Ltd, Ota-ku, Tokyo (JP)
(74) Representative: Kensett, John Hinton

(57) **Abstract**

The OFDM modulation circuit system includes an IFFT unit (3) and an interpolation unit. The IFFT unit performs an IFFT operation by mapping a digital modulation signal onto a plurality of sub-carriers, and outputs the plurality of (N points) IFFT signals. The interpolation unit interpolates the N-point IFFT signals with a degree of interpolation of 2. The interpolation unit includes only the first-stage interpolator(5), or the first-stage interpolator and at least one combination of a complex multiplier cascade-connected to the first-stage interpolator and the second-stage interpolator (9). Each of the first-stage interpolator and the second-stage interpolator includes the first (5₁) and second (5₃)IIR digital all-pass filters for performing 90° phase shift and the first (5₂) and second (5₄) delay circuits for supplying a signal delay by an amount equal to the signal delay of the first and second IIR digital all-pass filters.

## Description

### BACKGROUND OF THE INVENTION

### 1. Field of the Invention

The present invention relates to orthogonal frequency division multiplex (OFDM) circuit systems, and more particularly, to an OFDM circuit system which is used in terrestrial digital broadcasts or a digital wireless system, such as a fast wireless local area network (LAN) in a multimedia mobile access communication (MMAC) system, and which suppresses the generation of higher harmonics without increasing the circuit size of an interpolator even when a comparatively large degree of interpolation is used for interpolating a modulation signal.

### 2. Description of the Related Art

In the field of broadcasting, terrestrial analog broadcasts are being replaced with terrestrial digital broadcasts which offer high-quality broadcasting and allow many broadcast channels to be transmitted. Digital broadcasting has already started mainly in the United States and Europe, and it is also expected that digital broadcasting will be put into practical use in Japan in the near future.

In the terrestrial digital broadcasting in Europe and Japan, the OFDM modulation method is employed. In a terrestrial digital broadcast transmitter for transmitting terrestrial digital broadcasts, an OFDM modulation circuit system for generating an OFDM modulation signal is used.

A known OFDM modulation circuit system used in a terrestrial digital broadcast transmitter includes an inverse fast Fourier transform (IFFT) circuit and an interpolation circuit. The IFFT circuit performs mapping of a digital modulation signal onto a plurality of sub-carriers, and performs IFFT processing on a plurality of points (N). The interpolation circuit interpolates an output signal of the IFFT circuit by using a frequency equal to an integral multiple of the sampling frequency.

Fig. 26 is a block diagram illustrating an example of the configuration of the above-described known OFDM modulation circuit system provided with an interpolation circuit for performing interpolation with a four-times sampling frequency.

Fig. 27 illustrates signal waveforms (frequency spectra) obtained in the above-described elements of the OFDM modulation circuit system shown in Fig. 26.

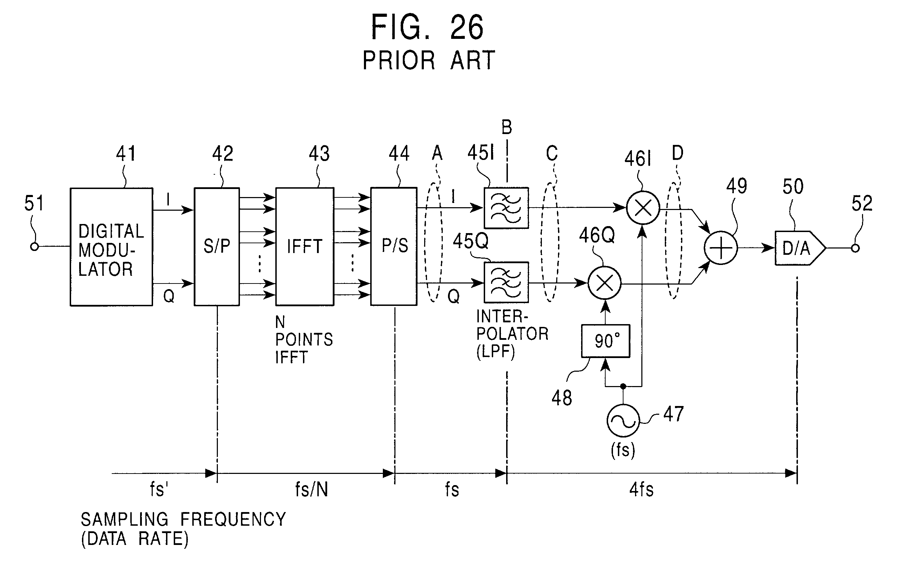

The OFDM modulation circuit system is formed of, as shown in Fig. 26, a digital modulator 41, a serial-to-parallel (S/P) converter 42, an IFFT unit 43, a parallel-to-serial (P/S) converter 44, an in-phase signal interpolator 45I including a finite impulse response (FIR) low-pass filter (LPF), an orthogonal signal interpolator 45Q including a FIR LPF, an in-phase signal multiplier 46I, an orthogonal signal multiplier 46Q, a local oscillator 47, a 90° phase shifter 48, an adder 49, and a digital-to-analog (D/A) converter 50. The in-phase signal interpolator 45I, the orthogonal signal interpolator 45Q, the in-phase signal multiplier 46I, the orthogonal signal multiplier 46Q, the local oscillator 47, and the 90° phase shifter 48 form the interpolation circuit. The in-phase signal multiplier 46I, the orthogonal signal multiplier 46Q, the local oscillator 47, the 90° phase shifter 48, and the adder 49 form an orthogonal modulation circuit.

The input of the digital modulator 41 is connected to a digital data input terminal 51, and the output thereof is connected to the input of the S/P converter 42. The input of the IFFT unit 43 is connected to the output of the S/P converter 42, and the output thereof is connected to the input of the P/S converter 44. The input of the in-phase signal interpolator 45I is connected to the in-phase output of the P/S converter 44, and the output thereof is connected to the first input of the in-phase signal multiplier 46I. The input of the orthogonal signal interpolator 45Q is connected to the orthogonal output of the P/S converter 44, and the output thereof is connected to the first input of the orthogonal signal multiplier 46Q. The second input of the in-phase signal multiplier 46I is connected to the output of the local oscillator 47, and the output thereof is connected to the first input of the adder 49. The second input of the orthogonal signal multiplier 46Q is connected to the output of the local oscillator 47 via the 90° phase shifter 48, and the output thereof is connected to the second input of the adder 49. The input of the D/A converter 50 is connected to the output of the adder 49, and the output thereof is connected to an analog signal output terminal 52.

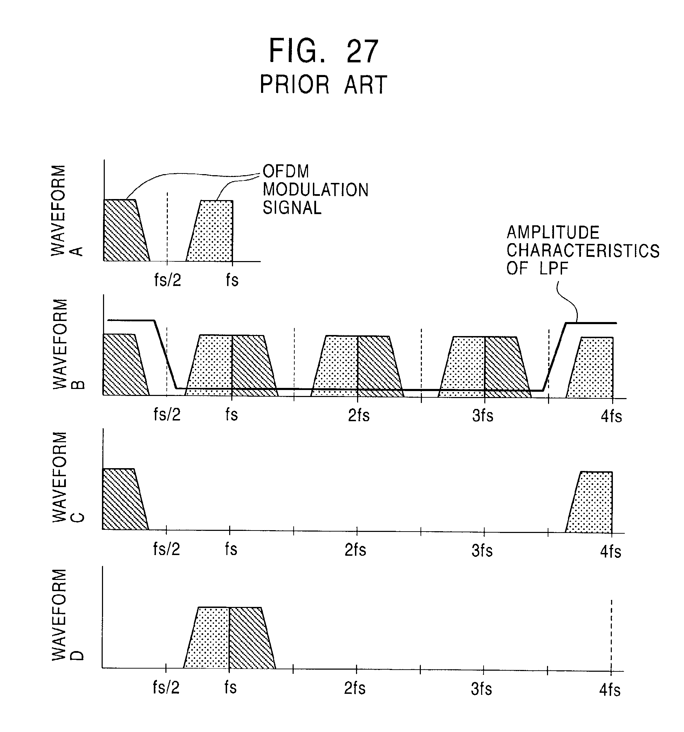

The operation of the above-configured OFDM modulation circuit system is described below with reference to Figs. 26 and 27.

Digital data output from a data generating source (not shown in Fig. 26) is supplied to the digital modulator 41 via the digital data input terminal 51. In the digital modulator 41, digital modulation, such as quadrature phase shift keying (QPSK), is performed on the digital data by using a sampling frequency fs', and an in-phase digital modulation signal (I) in phase with the input digital data and an orthogonal digital modulation signal (Q) out of phase with the input digital data by 90° are output from the digital modulator 41. Then, the in-phase digital modulation signal (I) and the orthogonal digital modulation signal (Q) undergo S/P conversion in the S/P converter 42, and are supplied to the IFFT unit 43 as an in-phase parallel signal and an orthogonal parallel signal, respectively. The IFFT unit 43 performs mapping of the in-phase parallel signal and the orthogonal parallel signal onto a plurality of sub-carriers, and also adds a plurality of carriers having the null value (0). Then, the IFFT unit 3 performs IFFT processing on a resulting plurality of points (N). As a result, N in-phase IFFT signals and N orthogonal IFFT signals are output from the IFFT unit 43. The N in-phase IFFT signals and the N orthogonal IFFT signals then undergo P/S conversion in the P/S converter 44, and the resulting in-phase serial signal (I) and the orthogonal serial signal (Q) are respectively supplied to the in-phase signal interpolator 45I and the orthogonal signal interpolator 45Q with a sampling frequency fs. The in-phase serial signal (I) and the orthogonal serial signal (Q) have signal spectra indicated by waveform A of Fig. 27.

In this case, the in-phase signal interpolator 45I and the orthogonal signal interpolator 45Q are each formed of a finite impulse response (FIR) digital filter, which performs interpolation with a sampling frequency 4fs obtained by multiplying the sampling frequency fs with the degree of interpolation n (n is an integer, which is 4 in this example). As a result, interpolation signals having frequency spectra indicated by waveform B of Fig. 27 are generated. Thereafter, signal components having three frequency spectra positioned at the intermediate portion of the signal band are removed from these interpolation signals due to the low-pass characteristics of the FIR digital LPF. Then, signals having two frequency spectra positioned at the ends of the signal band are extracted, as indicated by waveform C of Fig. 27, and are supplied to the in-phase signal multiplier 46I and the orthogonal signal multiplier 46Q.

The in-phase signal multiplier 46I receives not only the in-phase signal from the in-phase signal interpolator 45I, but also a local oscillation signal having the sampling frequency fs from the local oscillator 47. The in-phase signal multiplier 46I multiples the in-phase signal with the local oscillation signal. Meanwhile, the orthogonal signal multiplier 46Q receives not only the orthogonal signal from the orthogonal signal interpolator 45Q, but also a local oscillation signal obtained by shifting the local oscillation signal having the sampling frequency fs output from the local oscillator by 90° by the phase shifter 48. The orthogonal signal multiplier 46Q multiplies the orthogonal signal with the local oscillation signal output from the phase shifter 48. As a result, an in-phase signal and an orthogonal signal having frequency spectra indicated by waveform D of Fig. 27 are obtained. The in-phase signal and the orthogonal signal are added in the adder 49, and the resulting signal is supplied to the D/A converter 50 where it is D/A converted. The converted analog signal is supplied to the analog signal output terminal 52. In this case, the in-phase signal multiplier 46I, the orthogonal signal multiplier 46Q, the local oscillator 47, the 90° phase shifter 48, and the adder 49 form the orthogonal modulation circuit.

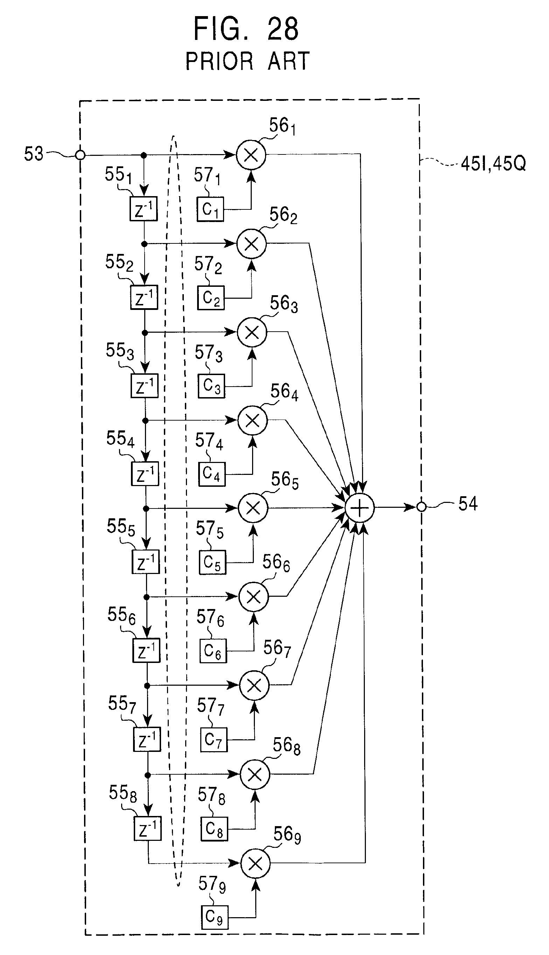

Fig. 28 is a circuit diagram illustrating the basic circuit of the FIR digital LPF used in the in-phase interpolator 45I or the orthogonal signal interpolator 45Q.

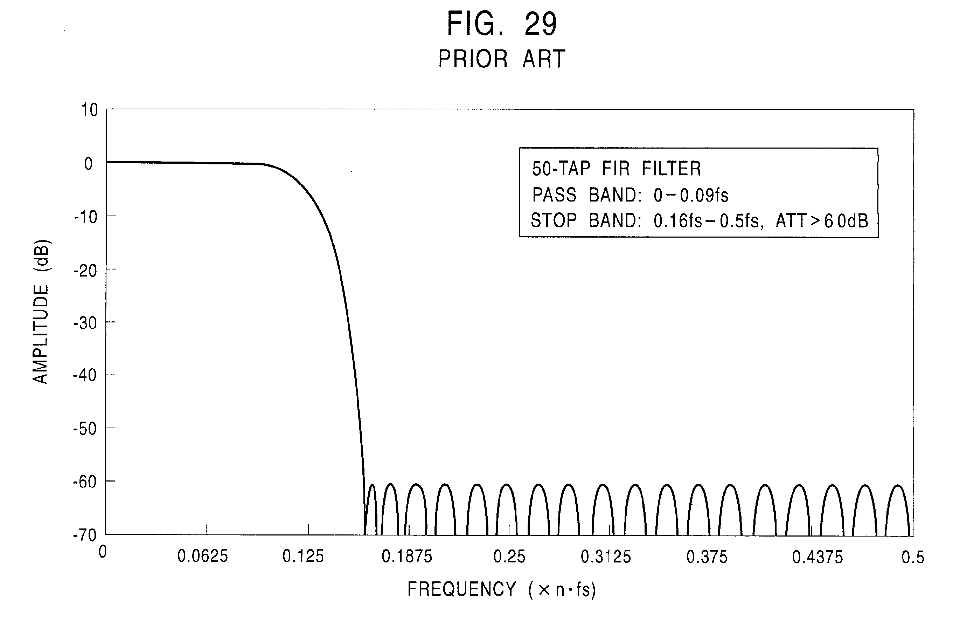

Fig. 29 is a diagram illustrating an example of the low-pass characteristics of the FIR digital LPF. The horizontal axis represents the sampling frequency in units of n·fs, and the vertical axis designates the signal amplitude in units of dB.

The FIR digital LPF 45I (45Q) includes, as shown in Fig. 28, an input terminal 53, an output terminal 54, eight delay units 55₁ through 55₈, nine multipliers 56₁ through 56₉, nine multiplication coefficient generators 57₁ through 57₉, and an adder 58. These elements are interconnected to each other, as shown in Fig. 28.

In the FIR digital LPF shown in Fig. 28, nine signal stages (taps) are provided. However, in order to obtain the low-pass characteristics in which the pass band having an amplitude of 0 dB ranges from 0 to 0.09fs, the stop band having an amplitude of -60 dB or lower ranges from 0.16 to 0.5fs, and the falling portion of the amplitude between the pass band and the stop band ranges from 0.09 to 0.16fs, 50 or more taps are required.

In the above-described OFDM modulation circuit system, if the degree of interpolation n for the FIR digital LPF used in the in-phase interpolator 45I or the orthogonal signal interpolator 45Q is set to a large value, such as 4, higher harmonics are generated over a wider band. It is thus necessary to suppress the higher harmonics, and also to sharpen the blocking characteristics of the FIR digital LPF according to the magnitude of the degree of interpolation. In a FIR digital LPF having sharp and wide blocking characteristics, 50 or more taps are required as discussed above, and accordingly, the size of the logic circuit of the OFDM modulation circuit system becomes large, thereby increasing the power consumption of the OFDM modulation circuit system.

### SUMMARY OF THE INVENTION

Accordingly, in view of the above technical background, it is an object of the present invention to provide an OFDM modulation circuit system in which the generation of higher harmonics is suppressed without increasing the size of a logic circuit used in the OFDM modulation circuit system by using cascade-connected interpolators having a degree of interpolation of 2 and provided with an infinite impulse response (IIR) digital all-pass filter.

In order to achieve the above object, according to one aspect of the present invention, an OFDM modulation circuit system provides a first function including: an IFFT unit for performing an IFFT operation by mapping a digital modulation signal onto a plurality of sub-carriers whose center frequency is one half a sampling frequency, and for outputting a plurality of IFFT signals; and an interpolation unit for sequentially interpolating according to the type of signal the plurality of IFFT signals, which are in-phase signals and orthogonal signals. The interpolation unit includes a first-stage interpolator for performing interpolation with a degree of interpolation of 2, and at least one combination of a complex multiplier for shifting frequency spectra to a higher range and a second-stage interpolator for performing interpolation with a degree of interpolation of 2. The above-described combination is cascade-connected to the first-stage interpolator.

According to the first function, the interpolation unit includes the first-stage interpolator for performing interpolation with a degree of interpolation of 2 and the second-stage interpolator for performing interpolation with a degree of interpolation of 2. With this configuration, interpolation is performed by the first-stage and second-stage interpolators so that the waveform of the temporally discrete sampling signals smoothly changes. Thus, higher harmonics are not generated in the signal band having the center frequency three times as high as the center frequency of the modulation signal, thereby effectively suppressing the generation of higher harmonics.

According to another aspect of the present invention, an OFDM modulation circuit system provides a second function including: an IFFT unit for performing an IFFT operation by mapping a digital modulation signal onto a plurality of sub-carriers whose center frequency is one half a sampling frequency, and for outputting a plurality of IFFT signals; and an interpolation unit for sequentially interpolating according to the type of signal the plurality of IFFT signals, which are in-phase signals and orthogonal signals. The interpolation unit includes a first-stage interpolator for performing interpolation with a degree of interpolation of 2, and at least one combination of a complex multiplier for shifting frequency spectra to a higher range and a second-stage interpolator for performing interpolation with a degree of interpolation of 2. The above-described combination is cascade-connected to the first-stage interpolator. Each of the first-stage and second-stage interpolators includes an IIF digital all-pass filter for shifting one of the in-phase signal and the orthogonal signal by 90 degrees, and a digital delay circuit for delaying the other one of the in-phase signal and the orthogonal signal by an amount equal to a signal delay of the IIR digital all-pass filter.

According to the second function, in addition to the first function, each interpolator is provided with the IIR digital all-pass filter and the digital delay circuit. With this configuration, the number of taps required for the IIR digital all-pass filter is much less than that of the FIR digital LPS used in a known interpolator. Thus, the size of the logic circuit can be significantly reduced, and accordingly, the power consumption of the OFDM modulation circuit system is reduced.

According to still another aspect of the present invention, an OFDM modulation circuit system provides a third function including: an IFFT unit for performing an IFFT operation by mapping a digital modulation signal onto a plurality of sub-carriers whose center frequency is one half a sampling frequency, and for outputting a plurality of IFFT signals; and an interpolator for sequentially interpolating according to the type of signal the plurality of IFFT signals, which are in-phase signals and orthogonal signals, with a degree of interpolation of 2.

According to the third function, in addition to the first function, only the single interpolator is used as the interpolation unit, and thus, the configuration of the OFDM modulation circuit system can be significantly simplified.

According to a further aspect of the present invention, an OFDM modulation circuit system provides a fourth function including: an IFFT unit for performing an IFFT operation by mapping a digital modulation signal onto a plurality of sub-carriers whose center frequency is one half a sampling frequency, and for outputting a plurality of IFFT signals; and an interpolator for sequentially interpolating according to the type of signal the plurality of IFFT signals, which are in-phase signals and orthogonal signals. The interpolator includes an IIR digital all-pass filter for shifting one of the in-phase signal and the orthogonal signal by 90 degrees, and a digital delay circuit for delaying the other one of the in-phase signal and the orthogonal signal by an amount equal to a signal delay of the IIR digital all-pass filter.

According to the fourth function, in addition to the third function, the single interpolator includes the IIR digital all-pass filter and the digital delay circuit. With this configuration, the number of taps required for the IIR digital all-pass filter is much less than that of the FIR digital LPF used in a known interpolator. Accordingly, the configuration of the OFDM modulation circuit system can be simplified, and also, the size of the logic circuit is reduced, thereby decreasing the power consumption of the OFDM modulation circuit system.

In this case, the IIR digital all-pass filter may include only the even-numbered signal processors, counting from the output side of the IIR digital all-pass filter, so that the signal processors can be operated with a frequency one half the operating frequency.

With this arrangement, the number of taps required for the IIR digital all-pass filter is even less than that of the signal processor used in the second or fourth function. Thus, the configuration of the IIR digital all-pass filter is even more simplified, and the size of the logic circuit is reduced, thereby reliably decreasing the power consumption of the OFDM modulation circuit system.

According to a yet further aspect of the present invention, an OFDM modulation circuit system provides a fifth function including: an IFFT unit for performing an IFFT operation by mapping a digital modulation signal onto a plurality of sub-carriers whose center frequency is one half a sampling frequency, and for outputting a plurality of IFFT signals; and an interpolation unit including a first-stage interpolation unit for sequentially interpolating according to the type of signal the plurality of IFFT signals, which are in-phase signals and orthogonal signals, and a final-stage interpolation unit for interpolating one of the in-phase signals and the orthogonal signals. The first-stage interpolation unit includes a first-stage interpolator for performing interpolation with a degree of interpolation of 2, or the first-stage interpolation unit includes the first-stage interpolator and at least one combination of a complex multiplier for shifting frequency spectra to a higher range, and a second-stage interpolator for performing interpolation with a degree of interpolation of 2. The above-described combination is cascade-connected to the first-stage interpolator. The final-stage interpolation unit includes a complex multiplier for shifting frequency spectra to a higher range and a third-stage interpolator cascade-connected to the complex multiplier so as to perform interpolation with a degree of interpolation of 2.

According to the fifth function, the interpolation unit includes the first-stage interpolation unit and the final-stage interpolation unit as described above. Interpolation is performed by using these interpolation units so that the waveform of the temporally discrete sampling signals smoothly changes. Accordingly, higher harmonics are not generated in the signal band having the center frequency three times as high as the center frequency of the modulation signal, thereby effectively suppressing the generation of higher harmonics. Additionally, since only one of the in-phase signal and the orthogonal signal is interpolated in the final-stage interpolation unit, the configuration of the third-stage interpolator, i.e., the configuration of the OFDM modulation circuit system, can be significantly simplified.

According to a further aspect of the present invention, an OFDM circuit system provides a sixth function including: an IFFT unit for performing an IFFT operation by mapping a digital modulation signal onto a plurality of sub-carriers whose center frequency is one half a sampling frequency, and for outputting a plurality of IFFT signals; and an interpolation unit including a first-stage interpolation unit for sequentially interpolating according to the type of signal the plurality of IFFT signals, which are in-phase signals and orthogonal signals, and a final-stage interpolation unit for interpolating one of the in-phase signals and the orthogonal signals. The first-stage interpolation unit includes a first-stage interpolator for performing interpolation with a degree of interpolation of 2, or the first-stage interpolation unit includes the first-stage interpolator and at least one combination of a complex multiplier for shifting frequency spectra to a higher range, and a second-stage interpolator for performing interpolation with a degree of interpolation of 2. The above-described combination is cascade-connected to the first-stage interpolator. The final-stage interpolation unit includes a complex multiplier for shifting frequency spectra to a higher range and a third-stage interpolator cascade-connected to the complex multiplier so as to perform interpolation with a degree of interpolation of 2. Each of the first-stage, second-stage, and third-stage interpolators includes an IIR digital all-pass filter for shifting one of the in-phase signals and the orthogonal signals by 90 degrees, and a digital delay circuit for delaying the other one of the in-phase signals and the orthogonal signals by an amount equal to a signal delay of the IIR digital all-pass filter.

According to the sixth function, in addition to the fifth function, each interpolator includes the IIR digital all-pass filter and the digital delay unit. With this configuration, the number of taps required for the IIR digital all-pass filter is much less than that of the FIR digital LPF of a known interpolator. Thus, the size of the logic circuit can be reduced, thereby decreasing the power consumption of the OFDM modulation circuit system.

According to a further aspect of the present invention, an OFDM modulation circuit system provides a seventh function including: an IFFT unit for performing an IFFT operation by mapping a digital modulation signal onto a plurality of sub-carriers whose center frequency is one half a sampling frequency, and for outputting a plurality of IFFT signals; and an interpolation unit including a single interpolator for interpolating the plurality of IFFT signals, which are in-phase signals, or the plurality of IFFT signals, which are orthogonal signals, with a degree of interpolation of 2.

According to the seventh function, in addition to the fifth function, since only the single interpolator is used as the interpolation unit. Thus, the configuration of the interpolation unit, i.e., the configuration of the OFDM modulation circuit system, can be considerably simplified.

According to a further aspect of the present invention, an OFDM modulation circuit system provides an eighth function including: an IFFT unit for performing an IFFT operation by mapping a digital modulation signal onto a plurality of sub-carriers whose center frequency is one half a sampling frequency, and for outputting a plurality of IFFT signals; and an interpolation unit including a single interpolator for interpolating the plurality of IFFT signals, which are in-phase signals, or the plurality of IFFT signals, which are orthogonal signals, with a degree of interpolation of 2. The interpolator includes an IIR digital all-pass filter for shifting one of the in-phase signals and the orthogonal signals by 90 degrees, and a digital delay circuit for delaying the other one of the in-phase signals and the orthogonal signals by an amount equal to a signal delay of the IIR digital all-pass filter.

According to the eighth function, in addition to the seventh function, the single interpolator includes the IIR digital all-pass filter and the digital delay circuit. With this configuration, the number of taps required for the IIR digital all-pass filter is much less than that of the FIR digital LPF of a known interpolator. Thus, the size of the OFDM modulation circuit system can be reduced, and also, the size of the logic circuit can be reduced, thereby decreasing the power consumption of the OFDM modulation circuit system.

In this case, each of the IIR digital all-pass filters according to the sixth function and the eights function may include only the even-numbered signal processors, counting from the output side of the IIR digital all-pass filter, so that the signal processors can be operated with a frequency one half the operating frequency.

With this arrangement, the number of taps required for the IIR digital all-pass filter is even less than that of the signal processor used in the sixth or eighth function. Thus, the configuration of the IIR digital all-pass filter is even more simplified, and the size of the logic circuit is reduced, thereby reliably decreasing the power consumption of the OFDM modulation circuit system.

According to a further aspect of the present invention, an OFDM modulation circuit system provides a ninth function including: an IFFT unit for performing an IFFT operation by mapping a digital modulation signal onto a plurality of sub-carriers whose center frequency is one half a sampling frequency, and for outputting a plurality of IFFT signals; an interpolation unit including one interpolator or a plurality of cascade-connected interpolators for sequentially interpolating according to the type of signal the plurality of IFFT signals, which are in-phase signals and orthogonal signals, with a degree of interpolation of 2; and an orthogonal modulator for orthogonal-modulating the in-phase interpolation signals and the orthogonal interpolation signals output from the interpolation unit.

According to the ninth function, the interpolation unit includes at least one interpolator or a plurality of cascade-connected interpolators, and interpolation is performed so that the waveform of the temporally discrete sampling signals smoothly changes. Thus, higher harmonics are not generated in the signal band having the center frequency three times as high as the center frequency of the modulation signal, thereby effectively suppressing the generation of higher harmonics.

According to a further aspect of the present invention, an OFDM modulation circuit system provides a tenth function including: an IFFT unit for performing an IFFT operation by mapping a digital modulation signal onto a plurality of sub-carriers whose center frequency is one half a sampling frequency, and for outputting a plurality of IFFT signals; an interpolation unit including at least one interpolator or a plurality of cascade-connected interpolators for sequentially interpolating according to the type of signal the plurality of IFFT signals, which are in-phase signals and orthogonal signals, with a degree of interpolation of 2; and an orthogonal modulator for orthogonal-modulating the in-phase interpolation signals and the orthogonal interpolation signals output from the interpolation unit. The interpolator includes an IIR digital all-pass filter for shifting one of the in-phase signals and the orthogonal signals by 90 degrees, and a digital delay circuit for delaying the other one of the in-phase signals and the orthogonal signals by an amount equal to a signal delay of the IIR digital all-pass filter.

According to the tenth function, in addition to the ninth function, the interpolator includes the IIR digital all-pass filter and the digital delay circuit. With this configuration, the number of taps required for the IIR digital all-pass filter is much less than that of the FIR digital LPF of a known interpolator. Thus, the size of the logic circuit can be reduced, thereby decreasing the power consumption of the OFDM modulation circuit system.

In this case, the IIR digital all-pass filter may includes only the even-numbered signal processors, counting from the output side of the IIR digital all-pass filter, so that the signal processors can be operated with a frequency one half the operating frequency.

With this arrangement, the number of taps required for the IIR digital all-pass filter is even less than that of the signal processor used in the tenth function. Thus, the configuration of the IIR digital all-pass filter is even more simplified, and the size of the logic circuit is reduced, thereby reliably decreasing the power consumption of the OFDM modulation circuit system.

### BRIEF DESCRIPTION OF THE DRAWINGS

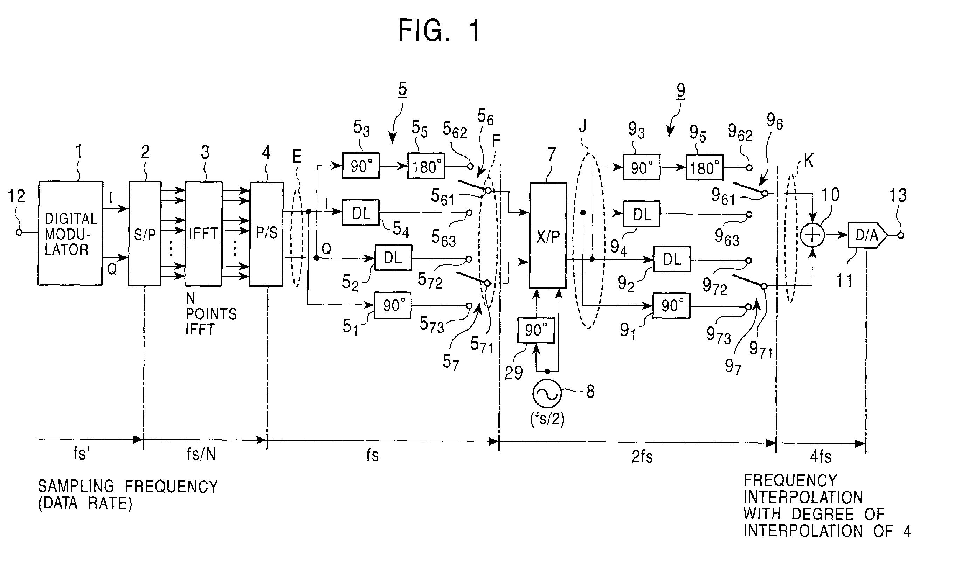

Fig. 1 is a block diagram illustrating the essential portions of an OFDM modulation circuit system according to a first embodiment of the present invention;

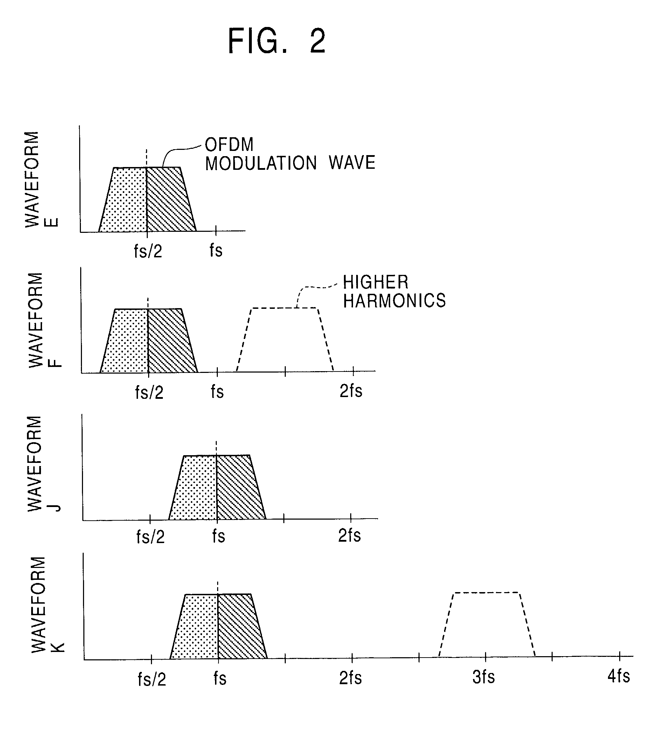

Fig. 2 illustrates signal waveforms obtained in the elements of the OFDM modulation circuit system shown in Fig. 1;

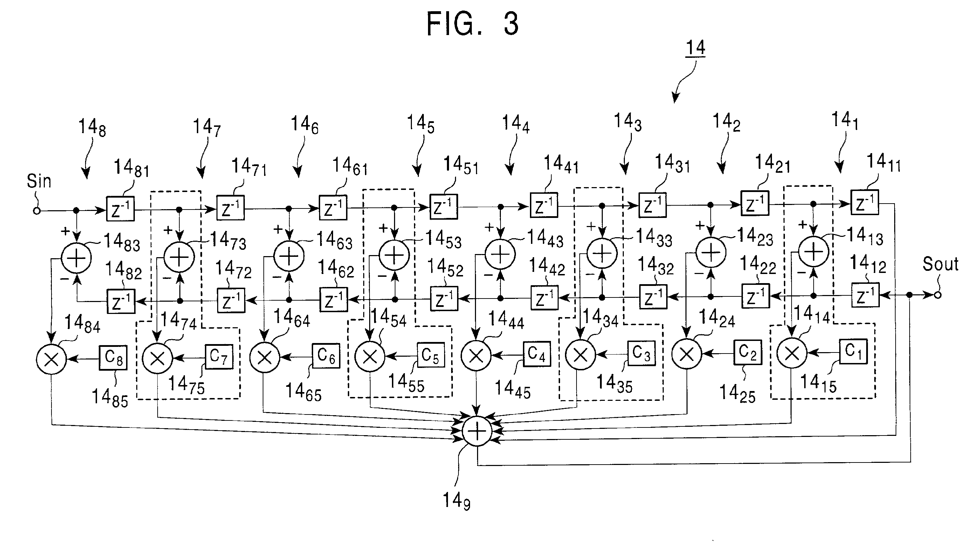

Fig. 3 is a circuit diagram illustrating one example of the specific configuration of an IIR digital filter;

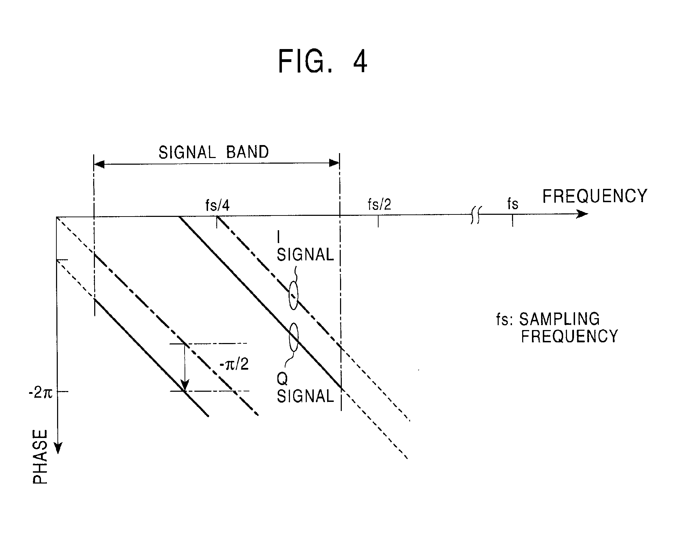

Fig. 4 illustrates the phase change of the IIR digital filter;

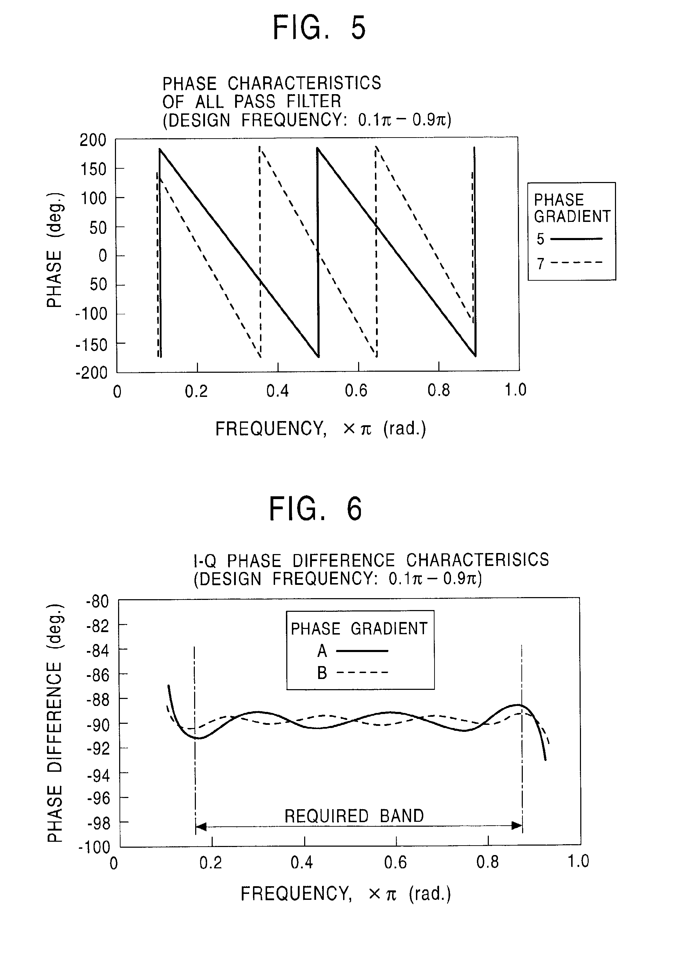

Fig. 5 illustrates the phase change according to a change in the phase gradient generated in the frequency pass band in the IIR digital filter;
Fig. 6 illustrates a change in the phase difference within the frequency pass band in the IIR digital filter shown in Fig. 5;

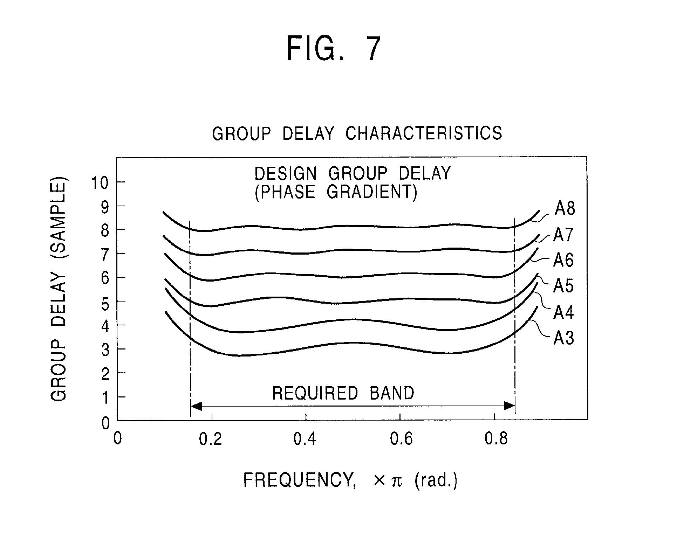

Fig. 7 illustrates a change in the group delay by using the phase gradient as a parameter in the IIR digital filter;

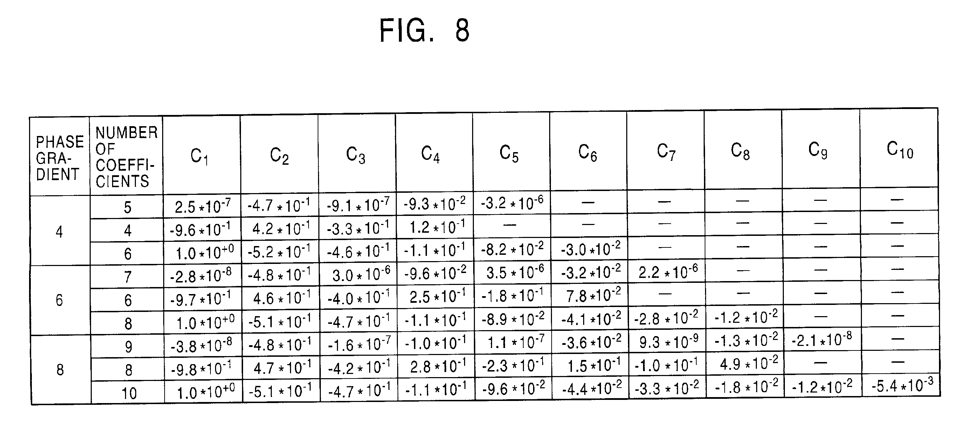

Fig. 8 is a table indicating examples of the coefficients set in the multiplication coefficient generators when the phase gradient and the number of taps are determined in the IIR digital filter;

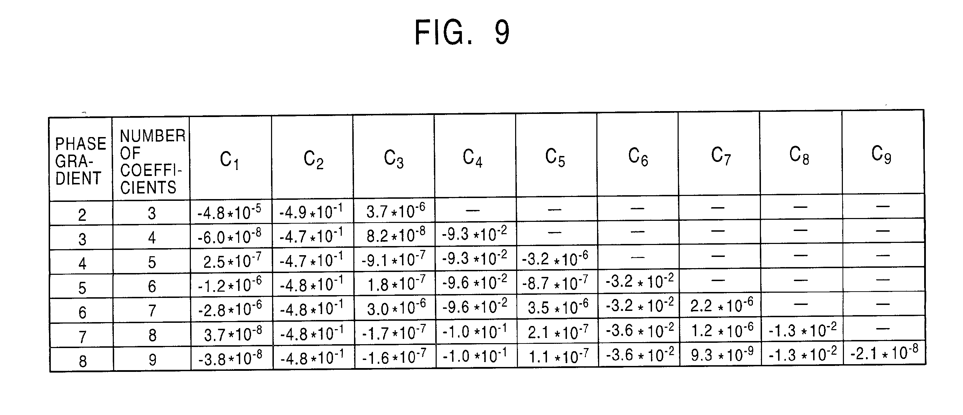

Fig. 9 is a table indicating the coefficients set in the multiplication coefficient generators when the number of coefficients is set by adding one to the phase gradient shown in Fig. 8;

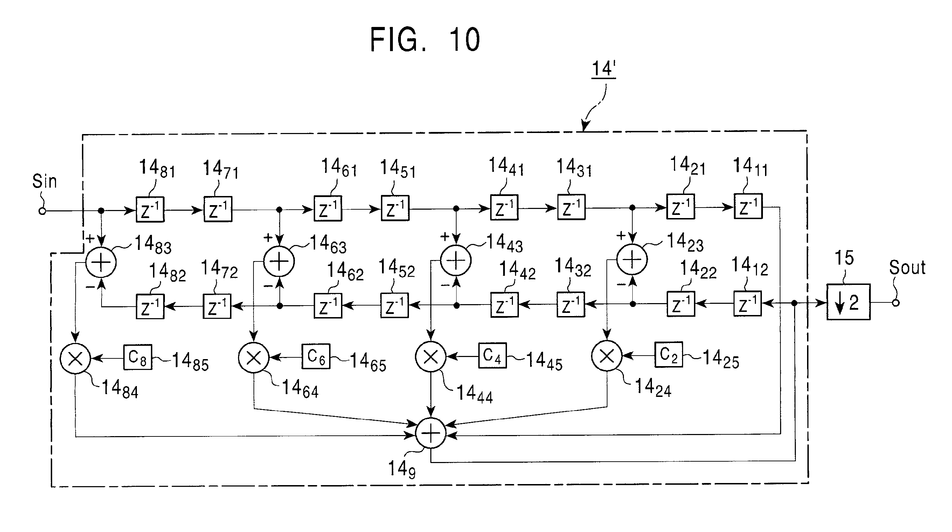

Fig. 10 is a circuit diagram of one example of the configuration of an IIR digital all-pass filter used in the in-phase signal interpolator or the orthogonal signal interpolator when the coefficients shown in Fig. 9 are set;

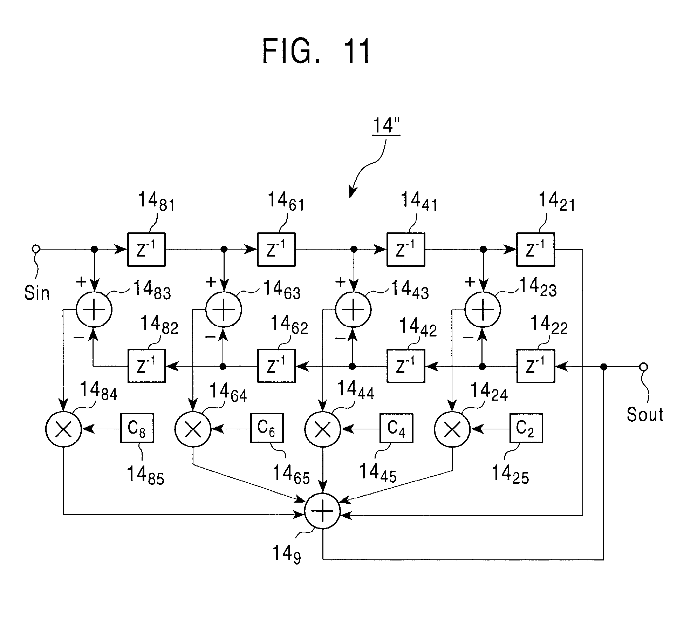

Fig. 11 is a circuit diagram illustrating another example of the configuration of an IIR digital all-pass filter used in the in-phase signal interpolator or the orthogonal signal interpolator when the coefficients shown in Fig. 9 are set;

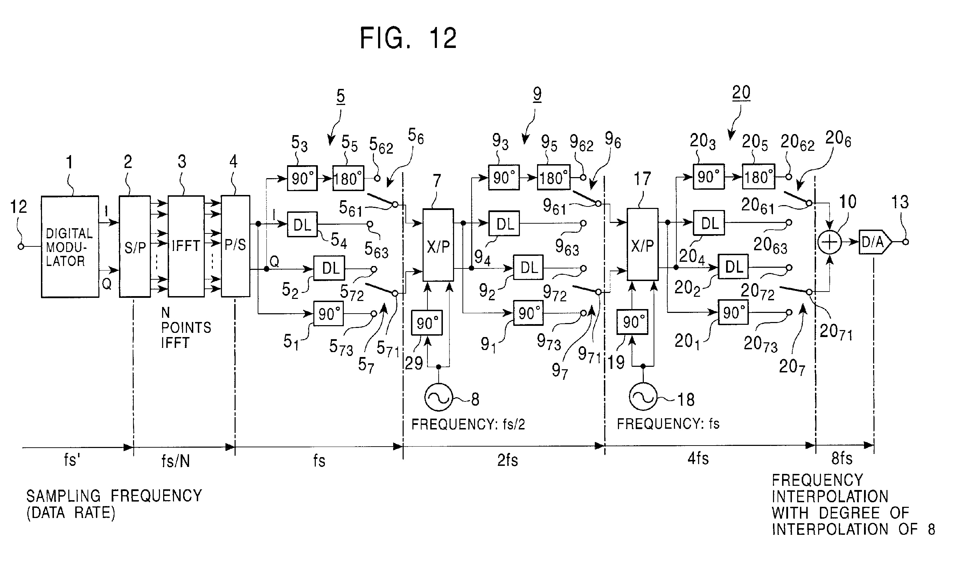

Fig. 12 is a block diagram illustrating the essential portions of an OFDM modulation circuit system according to a second embodiment of the present invention;

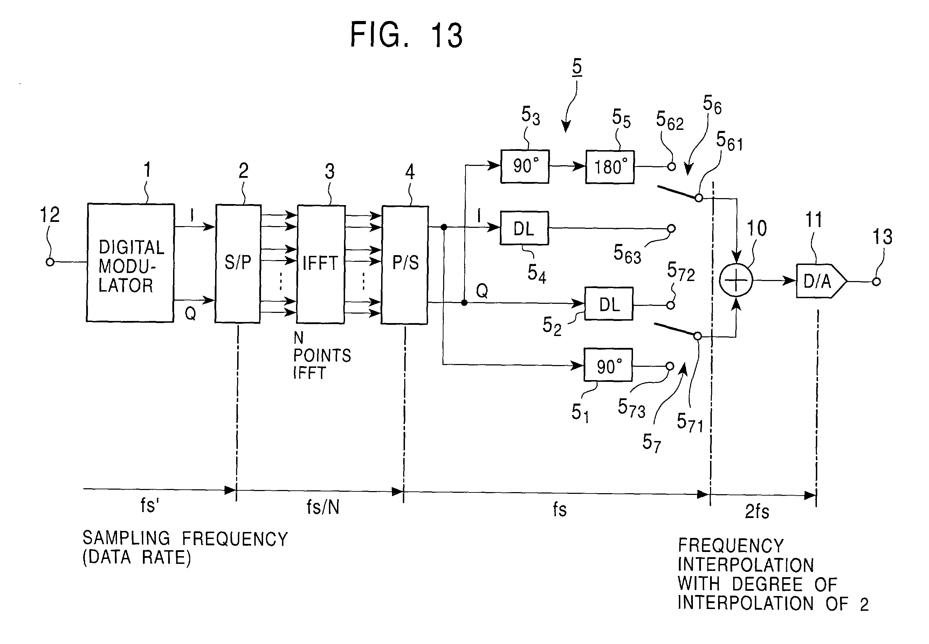

Fig. 13 is a block diagram illustrating the essential portions of an OFDM modulation circuit system according to a third embodiment of the present invention;

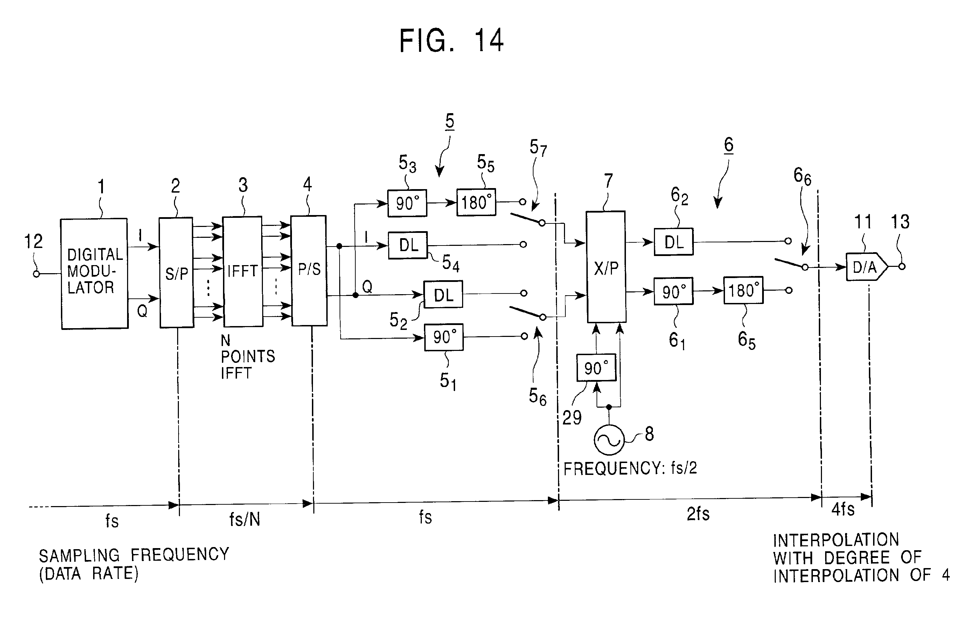

Fig. 14 is a block diagram illustrating the essential portions of an OFDM modulation circuit system according to a fourth embodiment of the present invention;

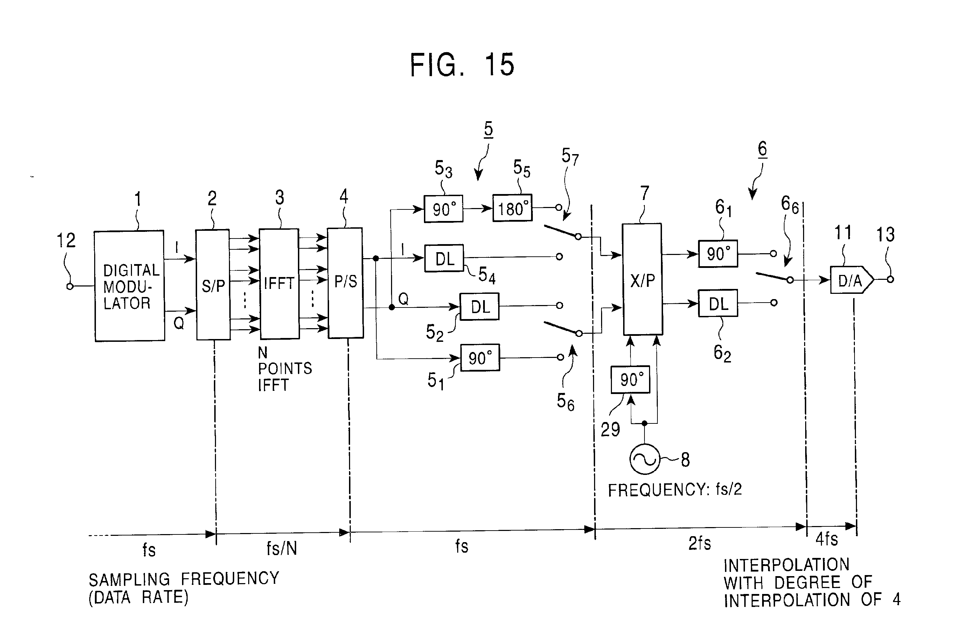

Fig. 15 is a block diagram illustrating the essential portions of an OFDM modulation circuit system according to a fifth embodiment of the present invention;

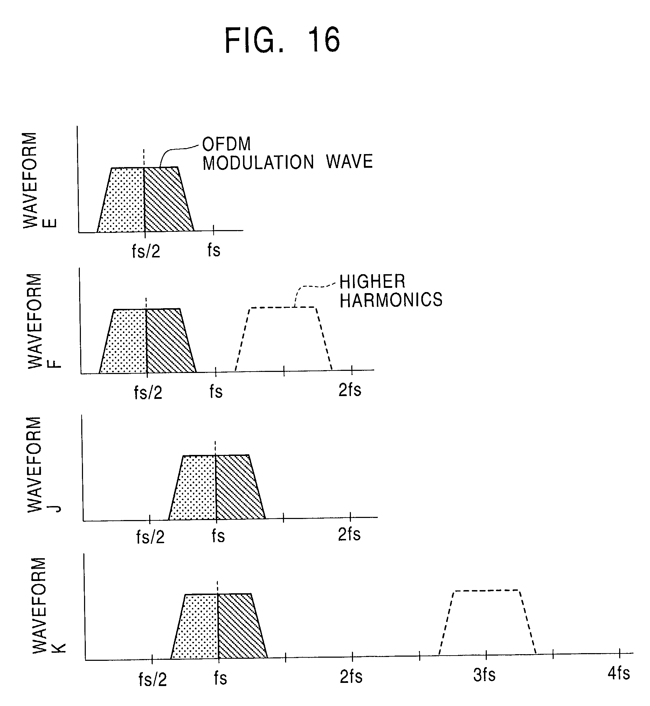

Fig. 16 illustrates signal waveforms obtained in the elements of the OFDM modulation circuit system shown in Fig. 14;

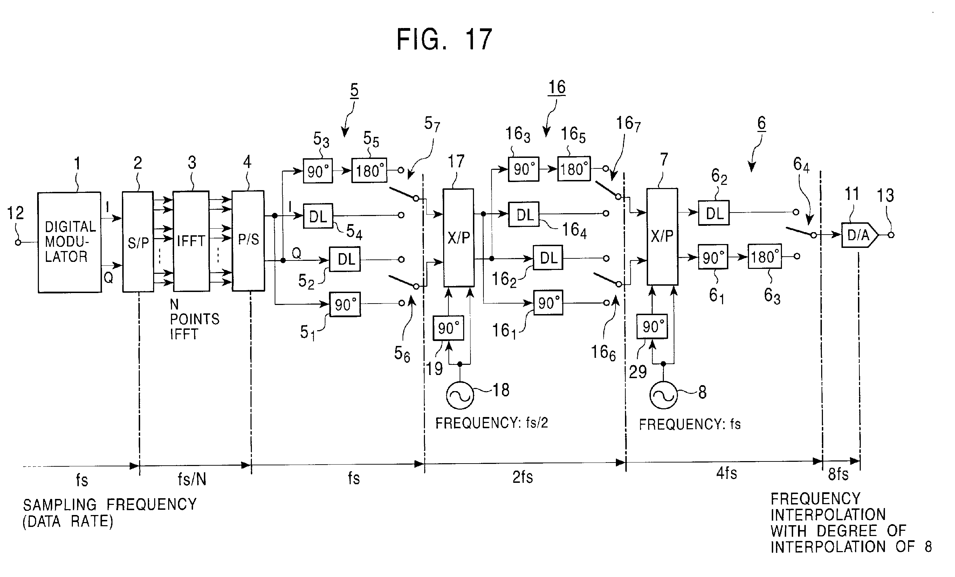

Fig. 17 is a block diagram illustrating the essential portions of an OFDM modulation circuit system according to a sixth embodiment of the present invention;

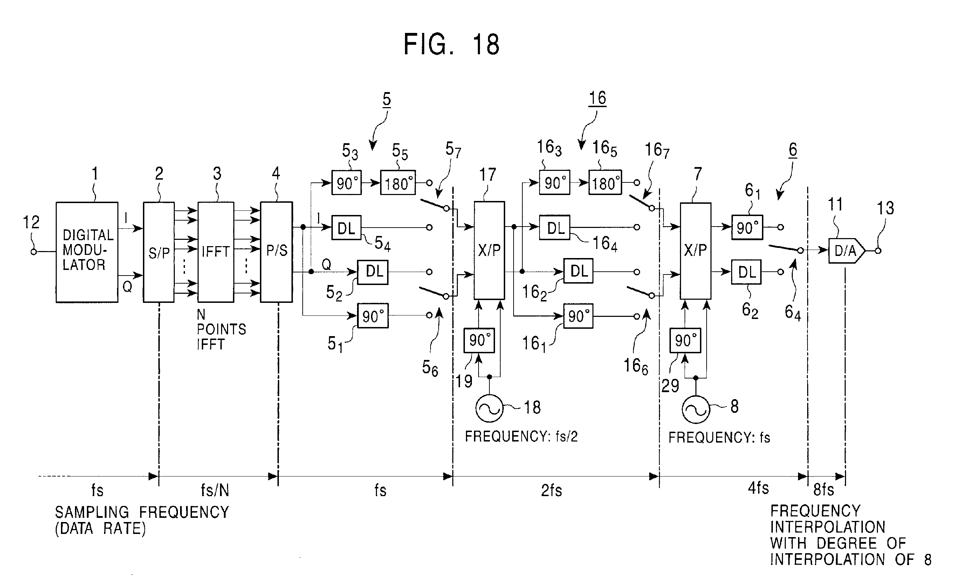

Fig. 18 is a block diagram illustrating the essential portions of an OFDM modulation circuit system according to a seventh embodiment of the present invention;

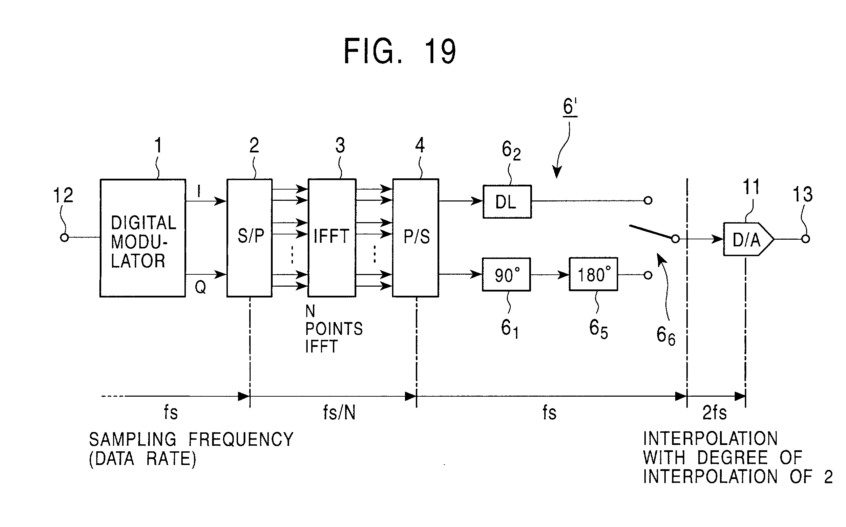

Fig. 19 is a block diagram illustrating the essential portions of an OFDM modulation circuit system according to an eighth embodiment of the present invention;

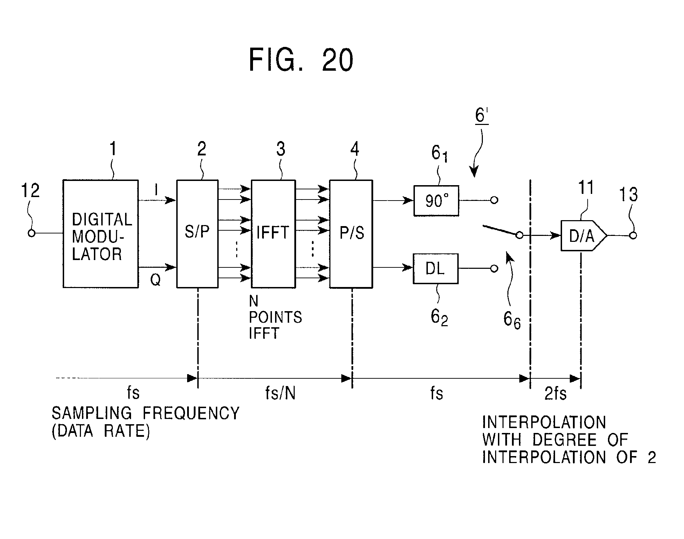

Fig. 20 is a block diagram illustrating the essential portions of an OFDM modulation circuit system according to a ninth embodiment of the present invention;

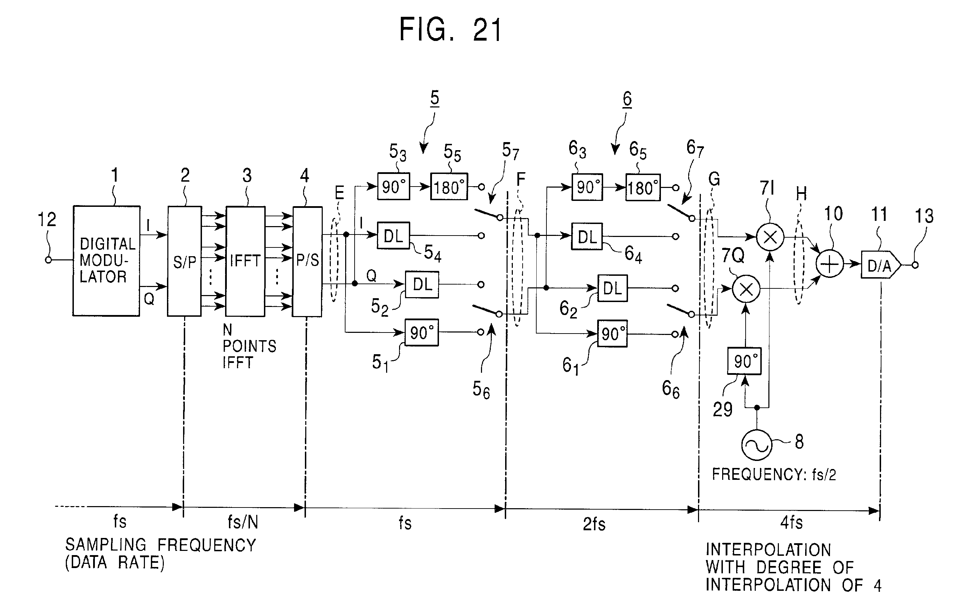

Fig. 21 is a block diagram illustrating the essential portions of an OFDM modulation circuit system according to a tenth embodiment of the present invention;

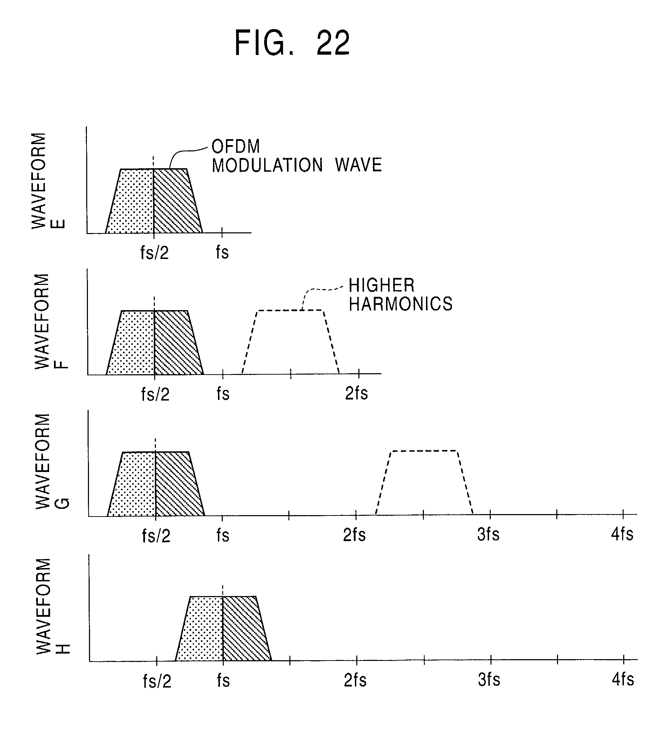

Fig. 22 illustrates signal waveforms obtained in the elements of the OFDM modulation circuit system shown in Fig. 21;

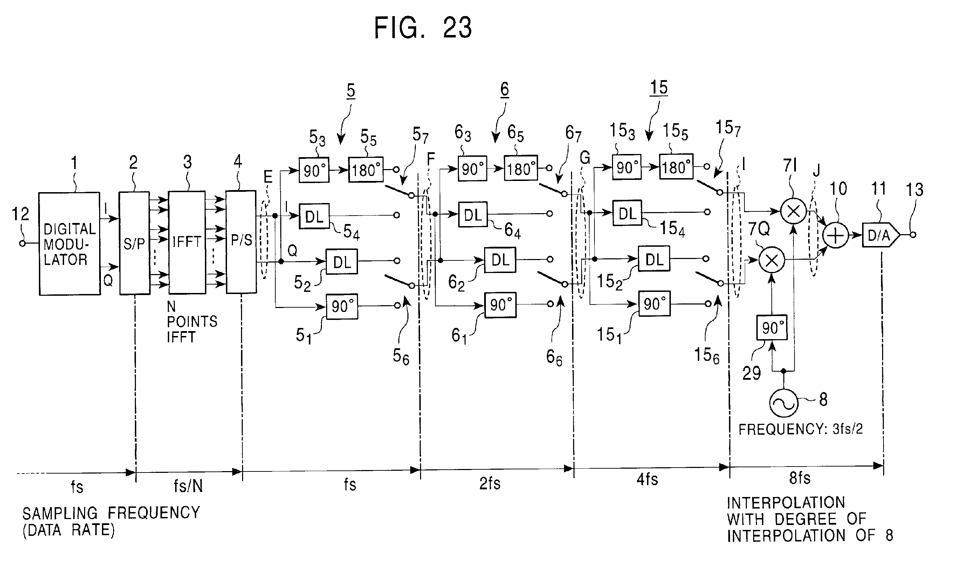

Fig. 23 is a block diagram illustrating the essential portions of an OFDM modulation circuit system according to an eleventh embodiment of the present invention;

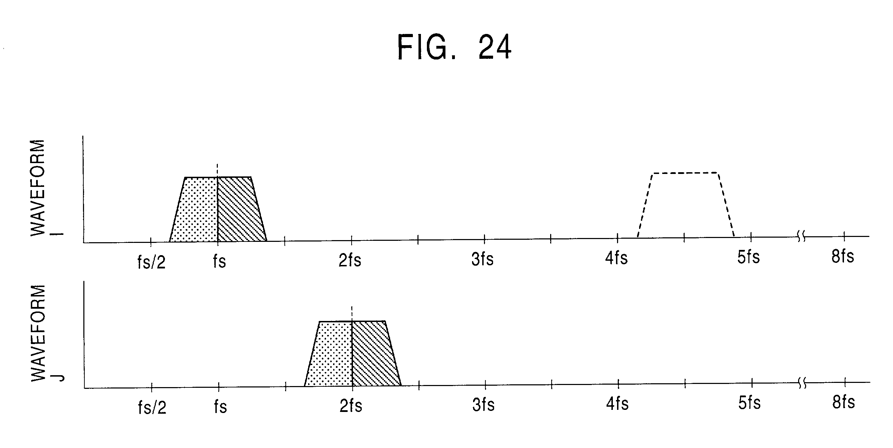

Fig. 24 illustrates signal waveforms obtained in the output circuit of the OFDM modulation circuit system shown in Fig. 23;

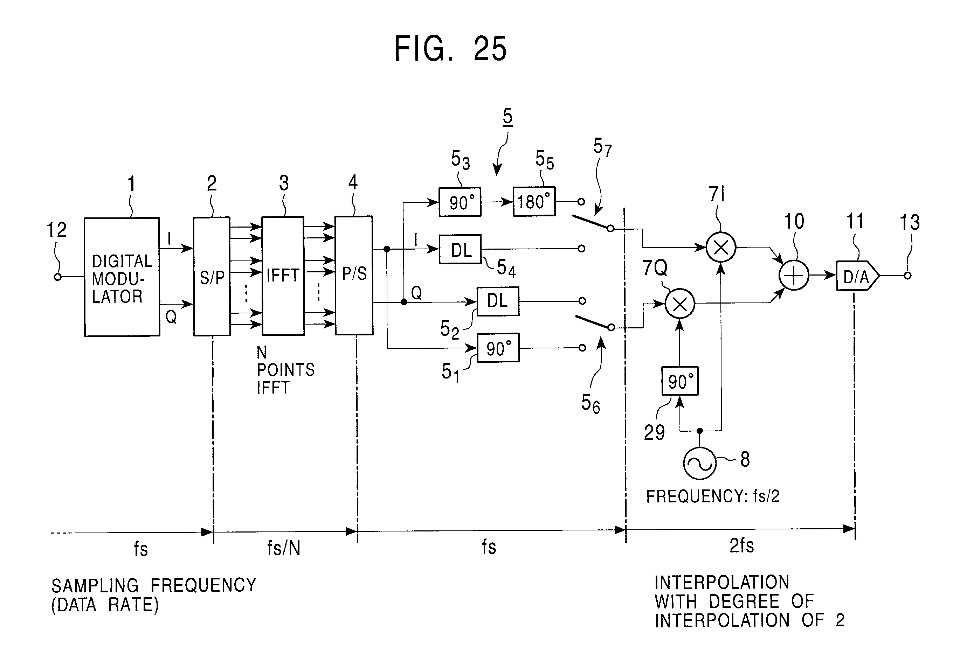

Fig. 25 is a block diagram illustrating the essential portions of an OFDM modulation circuit system according to a twelfth embodiment of the present invention;
Fig. 26 is a block diagram illustrating an example of the configuration of a known OFDM modulation circuit system;
Fig. 27 illustrates signal waveforms obtained in the elements of the OFDM modulation circuit system shown in Fig. 26;
Fig. 28 is a circuit diagram illustrating a FIR digital LPF used in the in-phase interpolator or the orthogonal signal interpolator; and
Fig. 29 illustrates an example of the low pass characteristics of the FIR digital LPF.

### DESCRIPTION OF THE PREFERRED EMBODIMENTS

The present invention is described in detail below with reference to the accompanying drawings through illustration of preferred embodiments.

Fig. 1 is a block diagram illustrating the configuration of an OFDM modulation circuit system according to a first embodiment of the present invention. In this OFDM modulation circuit system, two interpolators, each having a degree of interpolation of 2, are cascade-connected, thereby performing interpolation with a degree of interpolation of 4 in the entire OFDM modulation circuit system.

The OFDM modulation circuit system is formed of, as shown in Fig. 1, a digital modulator 1, an S/P converter 2, an IFFT unit 3, a P/S converter 4, a first-stage interpolator 5, a complex multiplier (cross product multiplier) 7, a local oscillator 8, a 90° phase shifter 29, a second-stage interpolator 9, an adder 10, a D/A converter 11, a digital data input terminal 12, and an analog signal output terminal 13.

In this case, the first-stage interpolator 5 includes a first infinite impulse response (IIR) digital all-pass filter 5₁, which forms a 90° phase shifter (indicated by 90° in Fig. 1), a first digital delay unit 5₂ (indicated by DL in Fig. 1) for supplying a signal having the same amount as the signal delay of the first IIR digital all-pass filter 5₁, a second IIR digital all-pass filter 5₃, which forms a 90° phase shifter (indicated by 90° in Fig. 1), a second digital delay unit 5₄ (indicated by DL in Fig. 1) for supplying a signal having the same amount as the signal delay of the second IIR digital all-pass filter 5₃, a 180° phase shifter (designated by 180° in Fig. 1) 5₅, a first single-pole double-throw switch 5₆, and a second single-pole double-throw switch 5₇. The second-stage interpolator 9 includes a first IIR digital all-pass filter 9₁, which forms a 90° phase shifter (indicated by 90° in Fig. 1), a first digital delay unit 9₂ (indicated by DL in Fig. 1) for supplying a signal having the same amount as the signal delay of the first IIR digital all-pass filter 9₁, a second IIR digital all-pass filter 9₃, which forms a 90° phase shifter (indicated by 90° in Fig. 1), a second digital delay unit 9₄ (indicated by DL in Fig. 1) for supplying a signal having the same amount as the signal delay of the second IIR digital all-pass filter 9₃, a 180° phase shifter (designated by 180° in Fig. 1) 9₅, a first single-pole double-throw switch 9₆, and a second single-pole double-throw switch 9₇.

The first single-pole double-throw switch 5₆ has a movable contact 5₆₁ and two stationary contacts 5₆₂ and 5₆₃ and the second single-pole double-throw switch 5₇ has a movable contact 5₇₁ and two stationary contacts 5₇₂ and 5₇₃. The first single-pole double-throw switch 9₆ has a movable contact 9₆₁ and two stationary contacts 9₆₂ and 9₆₃, and the second single-pole double-throw switch 9₇ has a movable contact 9₇₁ and two stationary contacts 9₇₂ and 9₇₃.

The input of the digital modulator 1 is connected to the digital data input terminal 12, and the output thereof is connected to the input of the S/P converter 2. The input of the IFFT unit 3 is connected to the output of the S/P converter 2, and the output thereof is connected to the input of the P/S converter 4. In the first-stage interpolator 5, the input of the first IIR digital all-pass filter 5₁ is connected to the I output of the P/S converter 4, and the output thereof is connected to the stationary contact 5₇₃. The input of the first digital delay unit 5₂ is connected to the Q output of the P/S converter 4, and the output thereof is connected to the stationary contact 5₇₂. The input of the second IIR digital all-pass filter 5₃ is connected to the Q output of the P/S converter 4, and the output thereof is connected to the input of the 180° phase shifter 5₅. The output of the 180° phase shifter 5₅ is connected to the stationary contact 5₆₂. The input of the second digital delay unit 5₄ is connected to the I output of the P/S converter 4, and the output thereof is connected to the stationary contact 5₆₃.

The first input of the complex multiplier 7 is connected to the movable contact 5₆₁, the second input thereof is connected to the movable contact 5₇₁, the third input thereof is connected to the output of the local oscillator 8, and the fourth input thereof is connected to the output of the 90° phase shifter 29. The input of the 90° phase shifter 29 is connected to the output of the local oscillator 8. In the second-stage interpolator 9, the input of the first IIR digital all-pass filter 9₁ is connected to the first output of the complex multiplier 7, and the output thereof is connected to the stationary contact 9₇₃. The input of the first digital delay unit 9₂ is connected to the second output of the complex multiplier 7, and the output thereof is connected to the stationary contact 9₇₂. The input of the second IIR digital all-pass filter 9₃ is connected to the second output of the complex multiplier 7, and the output thereof is connected to the input of the 180° phase shifter 9₅. The output of the 180° phase shifter 9₅ is connected to the stationary contact 9₆₂. The second digital delay unit 9₄ is connected to the first output of the complex multiplier 7, and the output thereof is connected to the stationary contact 9₆₃.

One input of the adder 10 is connected to the movable contact 9₆₁, the other input thereof is connected to the movable contact 9₇₁, and the output thereof is connected to the D/A converter 11. The output of the D/A converter 11 is connected to the analog signal output terminal 13.

Fig. 2 illustrates signal waveforms (frequency spectra) obtained in the above-described elements of the OFDM modulation circuit system shown in Fig. 1.

The operation of the above-configured OFDM modulation circuit system of the first embodiment is discussed below with reference to Figs. 1 and 2.

Digital data output from a data generating source (not shown in Fig. 1) is applied to the digital data input terminal 12, and is then supplied to the digital modulator 1. The digital modulator 1 performs digital modulation, such as QPSK, on the digital data by using a sampling frequency fs'. An in-phase digital modulation signal (I) in phase with the input digital data is output from the I output of the digital modulator 1. An orthogonal digital modulation signal (Q) out of phase with the input digital data by 90° is output from the Q output of the digital modulator 1. Then, the in-phase digital modulation signal (I) and the orthogonal digital modulation signal (Q) undergo S/P conversion in the S/P converter 2, and are supplied to the IFFT unit 3 as an in-phase parallel signal and an orthogonal parallel signal, respectively. The IFFT unit 3 performs mapping of the in-phase parallel signal and the orthogonal parallel signal onto a plurality of sub-carriers, and also adds a plurality of sub-carriers having the null value (0). Then, the IFFT unit 3 performs IFFT processing on the resulting plurality of points (N). As a result, N in-phase IFFT signals and N orthogonal IFFT signals are output from the IFFT unit 3. The N in-phase IFFT signals and the N orthogonal IFFT signals then undergo P/S conversion in the P/S converter 4. As a result, an in-phase serial signal and an orthogonal serial signal (modulation signals) having signal spectra whose center frequencies are 1/2 of the sampling frequency fs, as indicated by E of Fig. 2, are output. The in-phase serial signal and the orthogonal serial signal are supplied to the first-stage interpolator 5.

The first-stage interpolator 5 receives the in-phase serial signal and the orthogonal serial signal having the sampling frequency fs, and then performs signal interpolation on these signals. Then, the in-phase serial interpolation signal and the orthogonal serial interpolation signal 2fs having a frequency twice as high as the sampling frequency fs are output. In this case, signal interpolation is performed so that the signals change smoothly. Thus, even if the signals having the sampling frequency 2fs are output, higher harmonics are not generated within the frequency band having a center frequency 1.5fs, as indicated by waveform F.

Then, in the complex multiplexer 7, the in-phase serial interpolation signal and the orthogonal serial interpolation signal are respectively complex-multiplexed with the local oscillation signal having a frequency fs/2 output from the local oscillator 8 and the orthogonal local oscillation signal obtained by shifting the local oscillation signal output from the local oscillator 8 by 90° in the phase shifter 29. As a result, the in-phase serial interpolation signal and the orthogonal serial interpolation signal having a sampling frequency 2fs are output. The center frequency of the OFDM modulation signals is shifted by fs/2 to fs in a higher range, as indicated by waveform J of Fig. 2.

Subsequently, the second-stage interpolator 9 performs signal interpolation on the in-phase serial interpolation signal and the orthogonal serial interpolation signal output from the complex multiplexer 7 with a degree of interpolation of 2, thereby outputting the in-phase serial interpolation signal and the orthogonal serial interpolation signal having a sampling frequency 4fs. In this case, since the second-stage interpolator 9 performs signal interpolation similar to that performed by the first-stage interpolator 5, higher harmonics are not generated within the frequency range having a center frequency 3fs even if the in-phase serial interpolation signal and the orthogonal serial interpolation signal are output with a sampling frequency 4fs four times as high as the sampling frequency fs, as indicated by waveform K of Fig. 2.

Thereafter, the in-phase serial interpolation signal and the orthogonal serial interpolation signal, which are interpolated with a degree of interpolation of 4, are added in the adder 10, and the added signal is converted into an analog signal in the D/A converter 11. As a result, a serial interpolation signal which has an OFDM modulated signal component and which is interpolated with a degree of interpolation of 4 is output from the analog signal output terminal 13.

A description is now given of the process for generating the orthogonal serial interpolation signal by the first IIR digital all-pass filter 5₁, which serves as a 90° phase shifter, the first digital delay unit 5₂, and the second single-pole double-throw switch 5₇ of the first-stage interpolator 5.

As is well known, the orthogonal modulation signal is a signal having a 90° phase delay with respect to the in-phase modulation signal. Accordingly, if the in-phase modulation signal is delayed by 90°, it becomes in phase with the orthogonal modulation signal. Thus, in the first embodiment, the in-phase serial signal is delayed by 90° in the first IIR digital all-pass filter 5₁, and also, the orthogonal serial signal is delayed in the first digital delay unit 5₂ by an amount equal to a group delay time generated in the first IIR digital all-pass filter 5₁. As a consequence, the in-phase serial signal becomes in phase with the orthogonal serial signal. In this case, if the first IIR digital all-pass filter 5₁ is configured as described below, the serial signal output from the first IIR digital all-pass filter 5₁ is equal to a signal obtained by time-interpolating the serial signal output from the first digital delay unit 5₂. Thus, the output signal of the first IIR digital all-pass filter 5₁ and the output signal of the first digital delay unit 5₂ are signals having the sampling frequency fs. These signals are supplied to the second single-pole double-throw switch 5₇, and the movable contact 5₇₁ is switched with the two-times sampling frequency 2fs, thereby outputting the orthogonal serial interpolation signal interpolated with a degree of interpolation of 2 from the second single-pole double-throw switch 5₇.

A description is now given of the process for generating the in-phase serial interpolation signal by the second IIR digital all-pass filter 5₃, which serves as a 90° phase shifter, the second digital delay unit 5₄, the 180° phase shifter 5₅, and the first single-pole double-throw switch 5₆ of the first-stage interpolator 5.

As is well known, the in-phase modulation signal is a signal having a 90° phase lead or a 270° phase delay with respect to the orthogonal modulation signal. Accordingly, if the in-phase modulation signal is delayed by 270°, it becomes in phase with the orthogonal modulation signal. Thus, in the first embodiment, the orthogonal serial signal is delayed by 90° in the second IIR digital all-pass filter 5₃, and is further delayed by 180° in the 180° phase shifter 5₅. As a result, the orthogonal serial signal is delayed by 270°. A 180° phase delay is equal to the inversion of the signal polarity (sign), and thus, the 180° phase shifter 5₅ may be formed by an inverter for inverting the polarity (sign) of the digital signal.

Meanwhile, the in-phase serial signal is delayed by the second digital delay unit 5₄ by an amount equal to a group delay time generated in the second IIR digital all-pass filter 5₃. Thus, the in-phase serial signal becomes in phase with the orthogonal serial signal. In this case, if the second IIR digital all-pass filter 5₃ is configured as described below, the serial signal output from the second IIR digital all-pass filter 5₃ is equal to a signal obtained by time-interpolating the serial signal output from the second digital delay unit 5₄. These signals are supplied to the first single-pole double-throw switch 5₆, and the movable contact 5₆₁ is switched with the two-times sampling frequency 2fs, thereby outputting the in-phase serial interpolation signal interpolated with a degree of interpolation of 2 from the first single-pole double-throw switch 5₆.

As described above, the in-phase serial interpolation signal and the orthogonal serial interpolation signal, both of which are interpolated with a degree of interpolation of 2, are output from the first-stage interpolator 5.

The operation of the second-stage interpolator 9 is similar to that of the first-stage interpolator 5, except that the sampling frequency is two times as high as the sampling frequency of the first-stage interpolator 5, and an explanation thereof is thus omitted.

The IIR digital all-pass filter 5₁ or 5₃, which serves as the 90° phase shifter, is discussed below with reference to Figs. 3 through 10.

Fig. 3 is a circuit diagram illustrating the configuration of an IIR digital all-pass filter 14 used in the OFDM modulation circuit system of the present invention. The IIR digital all-pass filter 14 includes, as shown in Fig. 3, an input terminal Sin, an output terminal Sout, eight taps 14₁ through 14₈ sequentially connected to each other from the output terminal Sout to the input terminal Sin, and a common adder 14₉. The taps 14₁ through 14₈ are formed of first delay units 14₁₁ through 14₈₁, second delay units 14₁₂ through 14₈₂, adders 14₁₃ through 14₈₃, multipliers 14₁₄ through 14₈₄, and multiplication coefficient generators 14₁₅ through 14₈₅, respectively. In the taps 14₁ through 14₈, as shown in Fig. 3, the first delay units 14₁₁ through 14₈₁ are interconnected to each other, the second delay units 14₁₂ through 14₈₂ are interconnected to each other, the adders 14₁₃ through 14₈₃ are interconnected to each other, the multipliers 14₁₄ through 14₈₄ are interconnected to each other, and the multiplication coefficient generators 14₁₅ through 14₈₅ are interconnected to each other.

Fig. 4 illustrates the phase change of the IIR digital all-pass filter 14 in combination with the phase change of the digital signal delay unit.

In Fig. 4, the vertical axis and the horizontal axis represent the phase and the frequency, respectively. The solid lines indicate the phase change of the IIR digital all-pass filter 14, and the one-dot-chain lines indicate the phase change of the digital signal delay unit.

As shown in Fig. 4, the phase change of the digital signal delay unit in the signal band having the center frequency fs/4, which is one fourth the sampling frequency, (the region between the broken lines) is as follows. The phase value linearly changes from the lower limit frequency value to the upper limit frequency value in the signal band. When the phase value reaches -2π, it jumps to 0, and then linearly changes toward the upper limit frequency value. Similarly, the phase value of the IIR digital all-pass filter 14 linearly changes from the lower limit frequency value to the upper limit frequency value in the signal band with the same gradient as that of the digital signal delay unit. When the phase value reaches -2π, it jumps to 0, and then linearly changes toward the upper limit frequency value. Thus, the phase difference between the phase value of the IIR digital all-pass filter 14 and the phase value of the digital signal delay unit is always -(π/2), i.e., -90°.

In this case, the phase gradient indicates the ratio of the phase change with respect to the frequency change, and is defined by the number of frequency changes by -2π while the frequency ranges from 0 to fs. For example, if the accumulative phase while the frequency ranges from 0 to fs is -6π, the phase gradient is three.

The phase gradient also indicates the group delay time based on the sampling time. For example, if the phase gradient is three, the group delay time is three clocks.

Fig. 5 illustrates the phase change according to the phase gradient generated in the pass band in the IIR digital all-pass filter 14.

In Fig. 5, the vertical axis and the horizontal axis respectively indicate the phase in degrees and the frequency in radians (rad) (2π radian corresponding to the sampling frequency). The solid lines and the broken lines indicate the phase change when the phase gradient of the IIR digital all-pass filter 14 is 5 and 7, respectively.

By suitably selecting the delay constant Z⁻¹ of each of the first delay units 14₁₁ through 14₈₁ and each of the second delay units 14₁₂ through 14₈₂ and the coefficients C₁ through C₈ of the respective multiplication coefficient generators 14₁₅ through 14₈₅, the phase change of the IIR digital all-pass filter 14 becomes substantially linear in the digital signal frequency band (from 0.1π to 0.9π radians), as shown in Fig. 5. In the whole frequency band (0 to 2π radians), the phase change becomes those indicated by the solid line and the broken line shown in Fig. 5.

Fig. 6 illustrates the phase difference in the pass band between the phase of the IIR digital all-pass filter 14 and the phase of the digital signal delay unit.

In Fig. 6, the vertical axis and the horizontal axis respectively indicate the phase difference in degrees and the frequency in radians (rad). Curve A and curve B designate the phase differences when the phase gradient of the IIR digital all-pass filter 14 is 5 and 7, respectively.

As indicated by curve A and curve B shown in Fig. 6, although the IIR digital all-pass filter 14 has five or seven portions in which the phase difference changes in the digital signal frequency band (from 0.1π to 0.9π radians), the phase difference is always around -90°.

Fig. 7 illustrates a change in the group delay by using the phase gradient as a parameter in the IIR digital all-pass filter 14.

In Fig. 7, the vertical axis designates the group delay based on the number of samples, and the horizontal axis indicates the frequency in radians (rad). Curves A3 through A8 indicate changes in the group delay when the phase gradient is 3 through 8, respectively.

As shown in curves A3 through A8 in Fig. 7, although the change of the group delay of the IIR digital all-pass filter 14 gradually becomes smaller as the phase gradient increases from 3 to 8 in the digital signal frequency band (from 0.1π to 0.9π radians), the overall change is contained in a limited range.

In the IIR digital all-pass filter 14 having the above-described characteristics, the delay constant Z⁻¹ of each of the first delay units 14₁₁ through 14₈₁ and each of the second delay units 14₁₂ through 14₈₂ and the coefficients C₁ through C₈ of the respective multiplication coefficient generators 14₁₅ through 14₈₅ are suitably selected so that the phase gradient becomes, for example, three or more. Then, the phase difference between the orthogonal signal (Q) output from the IIR digital all-pass filter 14 and the in-phase signal (I) output from the digital signal delay unit is substantially 90° over the digital signal frequency band. Thus, the group delay of the orthogonal signal (Q) and that of the in-phase signal (I) are substantially the same.

Fig. 8 is a table indicating examples of the coefficients set in the multiplication coefficient generators when the phase gradient and the number of taps are determined in the IIR digital all-pass filter 14.

In Fig. 8, the leftmost column is the phase gradient, and the next column is the number of taps (indicated by the number of coefficients in Fig. 8). The remaining columns are the coefficients set in the multiplication coefficient generators (in Fig. 8, the coefficients set in the multiplication coefficient generators 14₁₅ through 14₈₅ shown in Fig. 3 are indicated by C₁ through C₈, and the coefficients of the ninth and tenth taps (not shown in Fig. 3) are indicated by C₉ and C₁₀).

In the first row, i.e., when the phase gradient is 4 and the number of coefficients is 5, as shown in Fig. 8, the coefficient C₁ is 2.5 × 10⁻⁷, the coefficient C₂ is -4.7 × 10⁻¹, the coefficient C₃ is -9.1 × 10⁻⁷, the coefficient C₄ is -9.3 × 10⁻², and the coefficient C₅ is -3.2 × 10⁻⁶. Similarly, in the second and subsequent rows, the coefficients C₁ through C₁₀ are set as shown in Fig. 8 according to the phase gradient and the number of coefficients.

When the phase gradient is 4 and the number of coefficients is 5, when the phase gradient is 6 and the number of coefficients is 7, and when the phase gradient is 8 and the number of coefficients is 9, the values of the exponents of the odd-numbered coefficients C₁, C₃, C₅, C₇, and C₉ are 10⁻⁶, 10⁻⁷, 10⁻⁸, or 10⁻⁹. If only five significant digits are used, the resulting coefficients become substantially 0.

Fig. 9 is a table illustrating the coefficients set in the multiplication coefficient generators when the number of coefficients is set by adding one to the phase gradient shown in Fig. 8.

In Fig. 9, the leftmost column is the phase gradient, the next column is the number of coefficients, and the remaining columns are the coefficients C₁ through C₉. That is, Fig. 9 illustrates the coefficients C₁ through C₉ when the phase gradient is m and the number of coefficients is m+1.

When the phase gradient is 2 to 8 and when the corresponding number of coefficients is 3 to 9, as shown in Fig. 9, the values of the exponents of all the odd-numbered coefficients C₁, C₃, C₅, C₇, and C₉ are 10⁻⁵, 10⁻⁶, 10⁻⁷, 10⁻⁸, or 10⁻⁹. Thus, the resulting coefficients become substantially 0.

If the relationship between the phase gradient and the number of coefficients (number of taps) is as described above, the coefficient of the multiplication coefficient generator becomes zero. Accordingly, the output data of the multiplier which multiples by the coefficient 0 also becomes zero, and the output data input into the multiplier becomes unnecessary. Thus, in the taps having the multiplication coefficient generators generating the coefficient 0, i.e., in the odd-numbered taps 14₁, 14₃, 14₅, and 14₇ surrounded by the broken lines in Fig. 3, the adders 14₁₃, 14₃₃, 14₅₃, and 14₇₃, the multipliers 14₁₄, 14₃₄, 14₅₄, and 14₇₄, and the multiplication coefficient generators 14₁₅, 14₃₅, 14₅₅, and 14₇₅ are not required, and these elements can be omitted.

Fig. 10 is a circuit diagram illustrating an IIR digital all-pass filter 14' without the adders 14₁₃, 14₃₃, 14₅₃, and 14₇₃, the multipliers 14₁₄, 14₃₄, 14₅₄, and 14₇₄, and the multiplication coefficient generators 14₁₅, 14₃₅, 14₅₅, and 14₇₅ of the odd-numbered taps as described above, and a decimator 15 inserted between the common adder 14₉ and the output terminal Sout. It is assumed that the phase gradient is m and the number of coefficients is m+1 in the IIR digital all-pass filter 14'.

The decimator 15 shown in Fig. 10 performs decimation by two, and more specifically, the decimator 15 decimates every alternate piece of the data supplied from the IIR digital all-pass filter 14', and supplies the output data having one half the data rate to the output terminal Sout. The coefficient C₂ of the multiplication coefficient generator 14₂₅ is set to -4.8 × 10⁻¹, the coefficient C₄ of the multiplication coefficient generator 14₄₅ is set to -1.0 × 10⁻¹, the coefficient C₆ of the multiplication coefficient generator 14₆₅ is set to -3.6 × 10⁻², and the coefficient C₈ of the multiplication coefficient generator 14₈₅ is set to -1.3 × 10⁻². In this case, when the sampling frequency of the IIR digital all-pass filter 14' is indicated by fi, the IIR digital all-pass filter 14' exhibits frequency characteristics in which the phase ripple in the frequency band from 0.05fi to 0.45fi is contained within ±1.5°.

In the IIR digital all-pass filter 14' provided with the decimator 15 shown in Fig. 10, the phase characteristics and the group delay characteristics at the input terminal of the decimator 15 are similar to those shown in Figs. 4 through 7. That is, the IIR digital all-pass filter 14' has predetermined phase characteristics and group delay characteristics in the pass band having the center frequency fi/4, which is one fourth the sampling frequency (data rate) fi. After the data passes through the decimator 15, the sampling frequency (data rate) fo of the output terminal Sout becomes fi/2 (=fo), which is one half the sampling frequency (data rate) fi of the IIR digital all-pass filter 14'. Thus, the above-described characteristics become those in the pass band having the center frequency fo/2. That is, based on the sampling frequency fi, the phase and group delay characteristics are those in the pass band having the center frequency fi/4.

In this case, the IIR digital all-pass filter 14' shown in Fig. 10 is suitable for use as the IIR digital all-pass filter 5₁, 5₃, 9₁, or 9₃.

The sampling frequency (data rate) of the IIR digital all-pass filter 5₁ or 5₃ shown in Fig. 1 is fs. Thus, in the IIR digital all-pass filter 14' shown in Fig. 10, the sampling frequency fo of the decimator 15 becomes fs, and the IIR digital all-pass filter 14' without the decimator 15 is operated with the sampling frequency 2fs (fi=2fs). The sampling frequency (data rate) of the IIR digital all-pass filter 9₁ or 9₃ shown in Fig. 1 is 2fs. Thus, in the IIR digital all-pass filter 14' shown in Fig. 10, the sampling frequency fo of the decimator 15 becomes 2fs, and the IIR digital all-pass filter 14' without the decimator 15 is operated with the sampling frequency 4fs (fi=2fs).

Fig. 11 is a circuit diagram illustrating the configuration of the IIR digital all-pass filter 14", which is similar to the counterpart shown in Fig. 10 and is suitable for use as the IIR digital all-pass filter 5₁, 5₃, 9₁, or 9₃.

In the IIR digital all-pass filter 14" shown in Fig. 11, the decimator 15 used for the IIR digital all-pass filter 14' shown in Fig. 10 is omitted, and all the odd-numbered taps 14₁, 14₃, 14₅, and 14₇ of the IIR digital all-pass filter 14 shown in Fig. 3 are completely omitted. The IIR digital all-pass filter 14" is operated with the same sampling frequency as that at the output terminal Sout of the IIR digital all-pass filter 14' shown in Fig. 10, i.e., one half the sampling frequency of the IIR digital all-pass filter 14'.

It is now assumed that the IIR digital all-pass filter 14" shown in Fig. 11 is used as the IIR digital all-pass filter 5₁ or 5₃ shown in Fig. 1. Since the output sampling frequency (data rate) of the IIR digital all-pass filter 5₁ or 5₃ is fs, the IIR digital all-pass filter 14" is also operated with the sampling frequency fs (fi=fs). Similarly, it is now assumed that the IIR digital all-pass filter 14" shown in Fig. 11 is used as the IIR digital all-pass filter 9₁ or 9₃ shown in Fig. 1. Since the output sampling frequency of the IIR digital all-pass filter 9₁ or 9₃ is 2fs, the IIR digital all-pass filter 14" is also operated with the sampling frequency 2fs (fi=2fs).

Upon comparison between the IIR digital all-pass filter 14 shown in Fig. 3 and the IIR digital all-pass filter 14' shown in Fig. 10, the number of circuit devices in the IIR digital all-pass filter 14' is less than that of the IIR digital all-pass filter 14, and the sampling frequency of the IIR digital all-pass filter 14' becomes one half the sampling frequency of the IIR digital all-pass filter 14, thereby achieving low power consumption. The same applies to the IIR digital all-pass filter 14" shown in Fig. 11.

As described above, according to the OFDM modulation circuit system of the first embodiment, signal interpolation is performed with a degree of interpolation of 4 by using the first-stage interpolator 5 including the first and second IIR digital all-pass filters 5₁ and 5₃ and the second-stage interpolator 9 including the first and second IIR digital all-pass filters 9₁ and 9₃. Only four taps are sufficient for the IIR digital all-pass filter 5₁, 5₃, 9₁, or 9₃, and the size of the overall logic circuit can be significantly reduced from that of a known OFDM modulation circuit system, thereby achieving a considerable reduction in the power consumption.

In the first embodiment, four taps are provided for the IIR digital all-pass filter 5₁, 5₃, 9₁, or 9₃ used in the first-stage interpolator 5 or the second-stage interpolator 9. However, the number of taps is not restricted to four, and a suitable number of taps may be provided according to the phase characteristics required in the IIR digital all-pass filter 5₁, 5₃, 9₁, or 9₃.

For example, if frequency selection characteristics in which the frequency band is 0.05fs to 0.45fs, and the phase ripple in the frequency band is within ±0.5° are required, the number of taps should be changed to five, and the coefficients of the multiplication coefficient generators are set as follows: C₂ = -4.9 × 10⁻¹, C₄ = -1.1 × 10⁻¹, C₆ = -4.0 × 10⁻², C₈ = -1.7 × 10⁻², and C₁₀ = -6.1 × 10⁻³.

If frequency selection characteristics in which the frequency band is a slightly smaller range, i.e., 0.1fs to 0.4fs, and the phase ripple in the frequency band is within ±1.5° are required, the number of taps should be changed to three, and the coefficients of the multiplication coefficient generators are set as follows: C₂ = -4.6 × 10⁻¹, C₄ = -7.1 × 10⁻², and C₆ = -1.3 × 10⁻².

Fig. 12 is a block diagram illustrating an OFDM modulation circuit system according to a second embodiment of the present invention. In the second embodiment, three interpolators having a degree of interpolation of 2 are used to perform frequency interpolation with a degree of interpolation of 8.

In addition to the elements of the OFDM modulation circuit system of the first embodiment, the OFDM modulation circuit system of the second embodiment is provided with a complex multiplexer (cross product arithmetic unit) 17, a local oscillator 18, a 90° phase shifter 19, and a third-stage interpolator 20. In Fig. 12, the same elements as those shown in Fig. 1 are designated with like reference numerals.

Basically, the second embodiment is configured similarly to the first embodiment, except that the second embodiment uses the first-stage interpolator 5, the complex multiplier 7, the second-stage interpolator 9, the complex multiplier 17, and the third-stage interpolator 20, while the first embodiment uses only the first-stage interpolator 5, the complex multiplexer 7, and the second-stage interpolator 9. The configurations of the elements related to the complex multiplier 17 and the third-stage interpolator 20 are substantially the same as those related to the complex multiplier 7 and the second-stage interpolator 9 of the first embodiment, and a further explanation of the configuration of the second embodiment is thus omitted.

The operations of the complex multiplier 17 and the third-stage interpolator 20 in the second embodiment are similar to those of the complex multiplier 7 and the second-stage interpolator 9, and the operations of the other elements are almost the same as those of the first embodiment. The advantages obtained by the second embodiment are also similar to those offered by the first embodiment, and a further explanation of the operation and the advantages of the second embodiment is thus omitted.

Fig. 13 is a block diagram illustrating an OFDM modulation circuit system according to a third embodiment of the present invention. In the OFDM modulation circuit system shown in Fig. 13, frequency interpolation is performed with a degree of interpolation of 2 by using one interpolator having a degree of interpolation of 2. In Fig. 13, the same elements as those shown in Fig. 1 are indicated by like reference numerals.

Basically, the third embodiment is configured similarly to the first embodiment, except that the third embodiment uses only the first-stage interpolator 5, while the first embodiment uses the first-stage interpolator 5, the second-stage interpolator 9, and the complex multiplier 7. Thus, a further explanation of the configuration of the third embodiment is thus omitted.

The operation of the first-stage interpolator 5 of the third embodiment is similar to that of the first embodiment, and the operation of the other elements is also similar to that of the first embodiment, except for the second-stage interpolator 9 and the complex multiplier 7 which are not provided for the third embodiment. The advantages obtained by the third embodiment are also similar to those achieved by the first embodiment, and a further explanation of the operation and the advantages of the third embodiment is thus omitted.

In the first, second, and third embodiments, signal interpolation is performed with a degree of interpolation of 4, 8, and 2, respectively. However, the degree of interpolation is not limited to those numbers, and it may be two to the power of N (i.e., 2, 4, 8, 16, and so on), and the number of interpolators and the number of complex multipliers are selected according to the required degree of interpolation.

In the first, second, and third embodiments, the output serial signal of the P/S converter 4 is supplied to the first-stage interpolator 5. However, a guard interval insertion unit for inserting a symbol which absorbs a propagating signal delay distortion may be connected between the P/S converter 4 and the first-stage interpolator 5, in which case, the output serial signal of the guard interval insertion unit is supplied to the first-stage interpolator 5.

Fig. 14 is a block diagram illustrating an OFDM modulation circuit system according to a fourth embodiment of the present invention. In the fourth embodiment, signal interpolation with a degree of interpolation of 4 is performed by using cascade-connecting two interpolators, each having a degree of interpolation of 2.

The OFDM modulation circuit system of the fourth embodiment includes, as shown in Fig. 14, a digital modulator 1, a S/P converter 2, an IFFT unit 3, a P/S converter 4, a first-stage interpolator 5, a final-stage interpolator 6, a complex multiplier (cross product computation unit) 7, a local oscillator 8, a 90° phase shifter 29, a D/A converter 11, a digital data input terminal 12, and an analog signal output terminal 13.

In this case, the first-stage interpolator 5 includes a first IIR digital all-pass filter 5₁, which forms a 90° phase shifter (indicated by 90° in Fig. 14), a first digital delay unit 5₂ (indicated by DL in Fig. 14) for supplying a signal having the same amount as the signal delay of the first IIR digital all-pass filter 5₁, a second IIR digital all-pass filter 5₃, which forms a 90° phase shifter (indicated by 90° in Fig. 14), a second digital delay unit 5₄ (indicated by DL in Fig. 14) for supplying a signal having the same amount as the signal delay of the second IIR digital all-pass filter 5₃, a 180° phase shifter (designated by 180° in Fig. 14) 5₅, a first single-pole double-throw switch 5₆, and a second single-pole double-throw switch 5₇. The final-stage interpolator 6 includes a first IIR digital all-pass filter 6₁, which forms a 90° phase shifter (indicated by 90° in Fig. 14), a first digital delay unit 6₂ (indicated by DL in Fig. 14) for supplying a signal having the same amount as the signal delay of the first IIR digital all-pass filter 6₁, a 180° phase shifter (designated by 180° in Fig. 14) 6₅, and a single-pole double-throw switch 6₆.

The input of the digital modulator 1 is connected to the digital data input terminal 12, and the output thereof is connected to the input of the S/P converter 2. The input of the IFFT unit 3 is connected to the output of the S/P converter 2, and the output thereof is connected to the input of the P/S converter 4. In the first-stage interpolator 5, the input of the first IIR digital all-pass filter 5₁ is connected to the I output of the P/S converter 4, and the output thereof is connected to one of the stationary contacts of the switch 5₆. The input of the first digital delay unit 5₂ is connected to the Q output of the P/S converter 4, and the output thereof is connected to the other stationary contact of the switch 5₆. The input of the second IIR digital all-pass filter 5₃ is connected to the Q output of the P/S converter 4, and the output thereof is connected to the input of the 180° phase shifter 5₅. The output of the 180° phase shifter 5₅ is connected to one of the stationary contacts of the switch 5₇. The input of the second digital delay unit 5₄ is connected to the I output of the P/S converter 4, and the output thereof is connected to the other stationary contact of the switch 5₇.

In the final-stage interpolator 6, the input of the first IIR digital all-pass filter 6₁ is connected to the second output of the complex multiplier 7, and the output thereof is connected to the input of the 180° phase shifter 6₅. The output of the 180° phase shifter 6₅ is connected to one of the stationary contacts of the switch 6₆. The input of the first digital delay unit 6₂ is connected to the first output of the complex multiplier 7, and the output thereof is connected to the other stationary contact of the switch 6₆. The first input of the complex multiplier 7 is connected to the movable contact of the switch 5₆, the second input thereof is connected to the movable contact of the switch 5₇, the third input thereof is connected to the output of the local oscillator 8, and the fourth input thereof is connected to the output of the 90° phase shifter 29. The input of the 90° phase shifter 29 is connected to the output of the local oscillator 8. The input of the D/A converter 11 is connected to the movable contact of the switch 6₆, and the output thereof is connected to the analog signal output terminal 13.

Fig. 16 illustrates signal waveforms (frequency spectra) obtained in the above-described elements of the OFDM modulation circuit system shown in Fig. 14.

The operation of the above-configured OFDM modulation circuit system of the fourth embodiment is discussed below with reference to Figs. 14 and 16.

Digital data output from a data generating source (not shown in Fig. 14) is applied to the digital data input terminal 12, and is then supplied to the digital modulator 1. The digital modulator 1 performs digital modulation, such as QPSK, on the digital data by using a sampling frequency fs'. An in-phase digital modulation signal (I) in phase with the input digital data is output from the I output of the digital modulator 1. An orthogonal digital modulation signal (Q) out of phase with the input digital data by 90° is output from the Q output of the digital modulator 1. Then, the in-phase digital modulation signal (I) and the orthogonal digital modulation signal (Q) undergo S/P conversion in the S/P converter 2, and are supplied to the IFFT unit 3 as an in-phase parallel signal and an orthogonal parallel signal, respectively. The IFFT unit 3 performs mapping of the in-phase parallel signal and the orthogonal parallel signal onto a plurality of sub-carriers, and also adds a plurality of sub-carriers having the null value (0). Then, the IFFT unit 3 performs IFFT processing on the resulting plurality of points (N). As a result, N in-phase IFFT signals and N orthogonal IFFT signals are output from the IFFT unit 3. The N in-phase IFFT signals and the N orthogonal IFFT signals then undergo P/S conversion in the P/S converter 4. As a result, an in-phase serial signal and an orthogonal serial signal (modulation signals) having signal spectra whose center frequencies are 1/2 of the sampling frequency fs, as indicated by E of Fig. 16, are output. The in-phase serial signal and the orthogonal serial signal are supplied to the first-stage interpolator 5.

The first-stage interpolator 5 receives the in-phase serial signal and the orthogonal serial signal having the sampling frequency fs, and then performs signal interpolation on these signals. Then, the in-phase serial interpolation signal and the orthogonal serial interpolation signal having a frequency 2fs twice as high as the sampling frequency fs are output. In this case, signal interpolation is performed so that the signals change smoothly. Thus, even if the signals having the sampling frequency 2fs are output, higher harmonics are not generated within the frequency band having a center frequency 1.5fs, as indicated by waveform F of Fig. 16.

Then, in the complex multiplexer 7, the in-phase serial interpolation signal and the orthogonal serial interpolation signal are respectively complex-multiplexed with the local oscillation signal having a frequency fs/2 output from the local oscillator 8 and the orthogonal local oscillation signal obtained by shifting the local oscillation signal output from the local oscillator 8 by 90° in the phase shifter 29. As a result, an in-phase serial interpolation signal and an orthogonal serial interpolation signal having a sampling frequency 2fs are output. The center frequency of the OFDM modulation signals is shifted by fs/2 to fs in a higher range, as indicated by waveform J of Fig. 16.

Subsequently, the final-stage interpolator 6 performs signal interpolation on one of the in-phase serial interpolation signal and the orthogonal serial interpolation signal output from the complex multiplexer 7 with a degree of interpolation of 2. The reason for performing signal interpolation on only one of the in-phase serial interpolation signal and the orthogonal serial interpolation signal is that neither of the signals has DC components. According to this signal interpolation, the in-phase serial interpolation signal or the orthogonal serial interpolation signal having a sampling frequency 4fs is output from the final-stage interpolator 6. In this case, since the final-stage interpolator 6 performs signal interpolation similar to that performed by the first-stage interpolator 5, higher harmonics are not generated within the frequency range having a center frequency 3fs, as indicated by waveform K of Fig. 16, even though the in-phase serial interpolation signal or the orthogonal serial interpolation signal is output with a sampling frequency 4fs four times as high as the sampling frequency fs.

Thereafter, the in-phase serial interpolation signal or the orthogonal serial interpolation signal is supplied to the D/A converter 11 where it is converted into an analog signal. As a result, a serial interpolation signal which has an OFDM modulated signal component and which is interpolated with a degree of interpolation of 4 is output from the analog signal output terminal 13.

Fig. 15 is a block diagram illustrating an OFDM modulation circuit system according to a fifth embodiment of the present invention. In the fifth embodiment, frequency interpolation with a degree of interpolation of 4 is performed by using two interpolators, each having a degree of interpolation of 2. In Fig. 15, the same elements as those shown in Fig. 14 are designated with like reference numerals.

The fifth embodiment shown in Fig. 15 is different from the fourth embodiment shown in Fig. 14 in the following points. In the final-stage interpolator 6 shown in Fig. 15, the 180° phase shifter 6₅ is not provided. The first IIR digital all-pass filter 6₁, which forms a 90° phase shifter, is connected to the first output (in-phase output) of the complex multiplier 7, and the first digital delay unit 6₂ is connected to the second output (orthogonal output) of the complex multiplier 7. That is, the connection state of the first IIR digital all-pass filter 6₁ and the first digital delay unit 6₂ to the complex multiplier 7 is opposite to that of the fourth embodiment.

Because of the configuration of the final-stage interpolator 6 of the fifth embodiment, the operation thereof is also different from that of the fourth embodiment. More specifically, in the final-stage interpolator 6 of the fifth embodiment, by switching the movable contact of the switch 6₆, the interpolation signal obtained by interpolating the orthogonal signal with the in-phase signal shifted by 90° is output. In contrast, in the final-stage interpolator 6 of the fourth embodiment, by switching the movable contact of the switch 6₆, the interpolation signal obtained by interpolating the in-phase signal with the orthogonal signal shifted by 270° is output. However, there is no difference between the operation of the fifth embodiment and that of the fourth embodiment, except for the operation of the final-stage interpolator 6.

According to the difference of the operation in the final-stage interpolator 6, in the fifth embodiment, the interpolation signal obtained by interpolating the orthogonal signal with the in-phase signal is output from the final-stage interpolator 6, and in the fourth embodiment, the interpolation signal obtained by interpolating the in-phase signal with the orthogonal signal is output from the final-stage interpolator 6. However, both the interpolation signals are signals in the intermediate frequency band. Accordingly, the advantages obtained by the fifth embodiment are similar to those achieved by the fourth embodiment, except that the configuration of the fifth embodiment without the 180° phase shifter 6₆ becomes simpler.

Fig. 17 is a block diagram illustrating an OFDM modulation circuit system according to a sixth embodiment of the present invention. In the sixth embodiment, signal interpolation with a degree of interpolation of 8 is performed by using three interpolators, each having a degree of interpolation of 2.

In the sixth embodiment, as shown in Fig. 17, an intermediate stage consisting of a second-stage interpolator 16, a complex multiplier (cross product computation unit) 17, a local oscillator 18, and a 90° phase shifter 19 is interposed between a first-stage interpolator 5 and a complex multiplier 7. The second-stage interpolator 16 includes a first IIR digital all-pass filter 16₁, which forms a 90° phase shifter, (indicated by 90° in Fig. 17), a first digital delay unit 16₂ (indicated by DL in Fig. 17) for supplying a signal having the same amount as the signal delay of the first IIR digital all-pass filter 16₁, a second IIR digital all-pass filter 16₃, which forms a 90° phase shifter, (indicated by 90° in Fig. 17), a second digital delay unit 16₄ (indicated by DL in Fig. 17) for supplying the same amount of the signal delay of the second IIR digital all-pass filter 16₃, a 180° phase shifter 16₅ (indicated by 180° in Fig. 17), a first single-pole double-throw switch 16₆, and a second single-pole double-throw switch 16₇. In this case, the configuration of the second-stage interpolator 16 is similar to that of the first-stage interpolator 5 shown in Fig. 14, and the configuration of the portion formed of the complex multiplier 17, the local oscillator 18, and the 90° phase shifter 19 is similar to that of the portion formed of the complex multiplier 7, the local oscillator 8, and the 90° phase shifter 29 shown in Fig. 14.

In the sixth embodiment, by providing the complex multiplier 17, the local oscillator 18, and the 90° phase shifter 19, the center frequencies of the in-phase serial interpolation signal and the orthogonal serial interpolation signal output from the first-stage interpolator 5 are shifted by 1/2fs. By providing the second-stage interpolator 16, signal interpolation is performed on the in-phase serial interpolation signal and the orthogonal serial interpolation signal with a degree of interpolation of 2. As a result, an interpolation signal interpolated with a degree of interpolation of 8 is output from the final-stage interpolator 6.

The operations of the first-stage interpolator 5, the complex multiplier 7, and the final-stage interpolator 6 are similar to those of the counterparts of the fourth embodiment. The operations of the complex multiplier 17 and the second-stage interpolator 16 are also similar to those of the complex multiplier 7 and the final-stage interpolator 6, respectively, of the fourth embodiment. Thus, a further explanation of the operation and the advantages of the sixth embodiment is not given.

Fig. 18 is a block diagram illustrating an OFDM modulation circuit system according to a seventh embodiment of the present invention. In the seventh embodiment, frequency interpolation with a degree of interpolation of 8 is performed by using three interpolators, each having a degree of interpolation of 2. In Fig. 18, the same elements as those shown in Fig. 17 are designated with like references.

As shown in Fig. 18, the configuration of the final-stage interpolator 6 of the seventh embodiment is slightly different from that of the sixth embodiment. This difference is similar to the difference between the fifth embodiment and the fourth embodiment. More specifically, the final-stage interpolator 6 of the seventh embodiment is not provided with the 180° phase shifter 6₃ provided for the sixth embodiment. Then, the first IIR digital all-pass filter 6₁, which forms a 90° phase shifter, is connected to the first output (I output) of the complex multiplier 7, and the first digital delay unit 6₂ is connected to the second output (Q output) of the complex multiplier 7. That is, the connection state of the first IIR digital all-pass filter 6₁ and the first digital delay unit 6₂ to the complex multiplier 7 is opposite to that of the sixth embodiment.

Because of the configuration of the final-stage interpolator 6 of the seventh embodiment, the operation thereof is also different from that of the sixth embodiment. More specifically, in the final-stage interpolator 6 of the seventh embodiment, by switching the movable contact of the switch 6₄, the interpolation signal obtained by interpolating the orthogonal signal with the in-phase signal shifted by 90° is output. In contrast, in the final-stage interpolator 6 of the sixth embodiment, by switching the movable contact of the switch 6₄, the interpolation signal obtained by interpolating the in-phase signal with the orthogonal signal shifted by 270° is output. However, there is no difference between the operation of the seventh embodiment and that of the sixth embodiment, except for the operation of the final-stage interpolator 6.

According to the difference of the operation in the final-stage interpolator 6, in the seventh embodiment, the interpolation signal obtained by interpolating the orthogonal signal with the in-phase signal is output from the final-stage interpolator 6, and in the sixth embodiment, the interpolation signal obtained by interpolating the in-phase signal with the orthogonal signal is output from the final-stage interpolator 6. However, both the interpolation signals are signals in the intermediate frequency band. Accordingly, the advantages obtained by the seventh embodiment are similar to those achieved by the sixth embodiment, except that the configuration of the seventh embodiment without the 180° phase shifter 6₃ becomes simpler.

Fig. 19 is a block diagram illustrating an OFDM modulation circuit system according to an eighth embodiment of the present invention. In the eighth embodiment, frequency interpolation with a degree of interpolation of 2 is performed by using a single interpolator having a degree of interpolation of 2. In Fig. 19, the same elements as those shown in Fig. 14 are indicated by like reference numerals.

The configuration of the eighth embodiment is similar to that of the fourth embodiment, except that a single interpolator 6' is used as the final-stage interpolation means. Thus, a further explanation of the configuration of the eighth embodiment is not given.

The operation and the advantages of the interpolator 6' of the eighth embodiment are similar to those of the final-stage interpolator 6 of the fourth embodiment. The operation and the advantages of the other elements are also similar to those of the fourth embodiment, and a further explanation of the operation and the advantages of the eighth embodiment is not given.

Fig. 20 is a block diagram illustrating an OFDM modulation circuit system according to a ninth embodiment of the present invention. In the ninth embodiment, frequency interpolation with a degree of interpolation of 2 is performed by using a single interpolator having a degree of interpolation of 2. In Fig. 20, the same elements as those shown in Fig. 14 are designated with like reference numerals.

As shown in Fig. 20, in the ninth embodiment, the configuration of the interpolator 6' is slightly different from that of the eighth embodiment. This difference is similar to the difference between the fifth embodiment and the fourth embodiment or the difference between the seventh embodiment and the sixth embodiment. More specifically, the interpolator 6' of the ninth embodiment is not provided with the 180° phase shifter 6₃ provided for the eighth embodiment. Then, the first IIR digital all-pass filter 6₁, which forms a 90° phase shifter, is connected to the first output (I output) of the complex multiplier 7, and the first digital delay unit 6₂ is connected to the second output (Q output) of the complex multiplier 7. That is, the connection state of the first IIR digital all-pass filter 6₁ and the first digital delay unit 6₂ to the complex multiplier 7 is opposite to that of the eighth embodiment.

Because of the configuration of the interpolator 6' of the ninth embodiment, the operation thereof is also different from that of the eighth embodiment. More specifically, in the interpolator 6' of the ninth embodiment, by switching the movable contact of the switch 6₆, the interpolation signal obtained by interpolating the orthogonal signal with the in-phase signal shifted by 90° is output. In contrast, in the interpolator 6' of the eighth embodiment, by switching the movable contact of the switch 6₆, the interpolation signal obtained by interpolating the in-phase signal with the orthogonal signal shifted by 270° is output. However, there is no difference between the operation of the ninth embodiment and that of the eighth embodiment, except for the operation of the interpolator 6'.

According to the difference of the operation in the interpolator 6', in the ninth embodiment, the interpolation signal obtained by interpolating the orthogonal signal by the in-phase signal is output from the interpolator 6', and in the eighth embodiment, the interpolation signal obtained by interpolating the in-phase signal with the orthogonal signal is output from the interpolator 6'. However, both the interpolation signals are signals in the intermediate frequency band. Accordingly, the advantages obtained by the ninth embodiment are similar to those achieved by the eighth embodiment, except that the configuration of the ninth embodiment without the 180° phase shifter 6₃ becomes simpler.

In the fourth and fifth embodiments, signal interpolation is performed with a degree of interpolation of 4. In the sixth and seventh embodiments, signal interpolation is performed with a degree of interpolation of 8 is performed. In the eighth and ninth embodiments, signal interpolation is performed with a degree of interpolation of 2. However, the degree of interpolation is not limited to those numbers, and it may be two to the power of N, i.e., 2, 4, 8, 16, and so on, and the number of interpolators and the number of complex multipliers are selected according to the degree of interpolation.

Fig. 21 is a block diagram illustrating an OFDM modulation circuit system according to a tenth embodiment of the present invention. In the tenth embodiment, signal interpolation with a degree of interpolation of 4 is performed by cascade-connecting two interpolators, each having a degree of interpolation of 2.

The OFDM modulation circuit system of the tenth embodiment includes, as shown in Fig. 21, a digital modulator 1, a S/P converter 2, an IFFT unit 3, a P/S converter 4, a first-stage interpolator 5, a second-stage interpolator 6, an in-phase signal multiplier 7I, an orthogonal signal multiplier 7Q, a local oscillator 8, a 90° phase shifter 29, an adder 10, a D/A converter 11, a digital data input terminal 12, and an analog signal output terminal 13. The in-phase signal multiplier 7I, the orthogonal signal multiplier 7Q, the local oscillator 8, and the 90° phase shifter 29 form an orthogonal modulation circuit (orthogonal modulation means).

In this case, the first-stage interpolator 5 includes a first IIR digital all-pass filter 5₁, which forms a 90° phase shifter (indicated by 90° in Fig. 21), a first digital delay unit 5₂ (indicated by DL in Fig. 21) for supplying a signal having the same amount as the signal delay of the first IIR digital all-pass filter 5₁, a second IIR digital all-pass filter 5₃, which forms a 90° phase shifter (indicated by 90° in Fig. 21), a second digital delay unit 5₄ (indicated by DL in Fig. 21) for supplying a signal having the same amount as the signal delay of the second IIR digital all-pass filter 5₃, a 180° phase shifter (designated by 180° in Fig. 21) 5₅, a first single-pole double-throw switch 5₆, and a second single-pole double-throw switch 5₇. The second-stage interpolator 6 includes a first IIR digital all-pass filter 6₁, which forms a 90° phase shifter (indicated by 90° in Fig. 21), a first digital delay unit 6₂ (indicated by DL in Fig. 21) for supplying a signal having the same amount as the signal delay of the first IIR digital all-pass filter 6₁, a second IIR digital all-pass filter 6₃, which forms a 90° phase shifter (indicated by 90° in Fig. 21), a second digital delay unit 6₄ (indicated by DL in Fig. 21) for supplying a signal having the same amount as the signal delay of the second IIR digital all-pass filter 6₃, a 180° phase shifter (designated by 180° in Fig. 21) 6₅, and a first single-pole double-throw switch 6₆, and a second single-pole double-throw switch 6₇.

The input of the digital modulator 1 is connected to the digital data input terminal 12, and the output thereof is connected to the input of the S/P converter 2. The input of the IFFT unit 3 is connected to the output of the S/P converter 2, and the output thereof is connected to the input of the P/S converter 4.

In the first-stage interpolator 5, the input of the first IIR digital all-pass filter 5₁ is connected to the I output of the P/S converter 4, and the output thereof is connected to one of the stationary contacts of the switch 5₆. The input of the first digital delay unit 5₂ is connected to the Q output of the P/S converter 4, and the output thereof is connected to the other stationary contact of the switch 5₆. The input of the second IIR digital all-pass filter 5₃ is connected to the Q output of the P/S converter 4, and the output thereof is connected to the input of the 180° phase shifter 5₅. The output of the 180° phase shifter 5₅ is connected to one of the stationary contacts of the switch 5₇. The input of the second digital delay unit 5₄ is connected to the I output of the P/S converter 4, and the output thereof is connected to the other stationary contact of the switch 5₇.

In the second-stage interpolator 6, the input of the first IIR digital all-pass filter 6₁ is connected to the movable contact of the switch 5₇, and the output thereof is connected to the input of the 180° phase shifter 6₅. The output of the 180° phase shifter 6₅ is connected to one of the stationary contacts of the switch 6₆. The input of the first digital delay unit 6₂ is connected to the movable contact of the switch 5₆, and the output thereof is connected to the other stationary contact of the switch 6₆. The input of the second IIR digital all-pass filter 6₃ is connected to the movable contact of the switch 5₆, and the output thereof is connected to the input of the 180° phase shifter 6₅. The output of the 180° phase shifter 6₅ is connected to one of the stationary contacts of the switch 6₇. The input of the second digital delay unit 6₄ is connected to the movable contact of the switch 5₇, and the output thereof is connected to the other stationary contact of the switch 6₇.

The first input of the in-phase signal multiplier 7I is connected to the movable contact of the switch 6₇, the second input thereof is connected to the output of the local oscillator 8, and the output thereof is connected to the first input of the adder 10. The first input of the orthogonal signal multiplier 7Q is connected to the movable contact of the switch 6₆, the second input thereof is connected to the output of the 90° phase shifter 29, and the output thereof is connected to the second input of the adder 10. The input of the 90° phase shifter 29 is connected to the output of the local oscillator 8. The output of the adder 10 is connected to the input of the D/A converter 11. The output of the D/A converter 11 is connected to the analog signal output terminal 13.

Fig. 22 illustrates signal waveforms (frequency spectra) obtained in the above-described elements of the OFDM modulation circuit system shown in Fig. 21.

The operation of the above-configured OFDM modulation circuit system of the tenth embodiment is discussed below with reference to Figs. 21 and 22.

Digital data output from a data generating source (not shown in Fig. 21) is applied to the digital data input terminal 12, and is then supplied to the digital modulator 1. The digital modulator 1 performs digital modulation, such as QPSK, on the digital data by using a sampling frequency fs'. An in-phase digital modulation signal (I) in phase with the input digital data is output from the I output of the digital modulator 1. An orthogonal digital modulation signal (Q) out of phase with the input digital data by 90° is output from the Q output of the digital modulator 1. Then, the in-phase digital modulation signal (I) and the orthogonal digital modulation signal (Q) undergo S/P conversion in the S/P converter 2, and are supplied to the IFFT unit 3 as an in-phase parallel signal and an orthogonal parallel signal, respectively. The IFFT unit 3 performs mapping of the in-phase parallel signal and the orthogonal parallel signal onto a plurality of sub-carriers, and also adds a plurality of sub-carriers having the null value (0). Then, the IFFT unit 3 performs IFFT processing on the resulting plurality of points (N). As a result, N in-phase IFFT signals and N orthogonal IFFT signals are output from the IFFT unit 3. The N in-phase IFFT signals and the N orthogonal IFFT signals then undergo P/S conversion in the P/S converter 4. As a result, an in-phase serial signal and an orthogonal serial signal (modulation signals) having signal spectra whose center frequencies are 1/2 of the sampling frequency fs, as indicated by E of Fig. 22, are output. The in-phase serial signal and the orthogonal serial signal are supplied to the first-stage interpolator 5.

The first-stage interpolator 5 receives the in-phase serial signal and the orthogonal serial signal having the sampling frequency fs, and then performs signal interpolation on these signals. Then, the in-phase serial interpolation signal and the orthogonal serial interpolation signal 2fs having a frequency twice as high as the sampling frequency fs are output and are supplied to the second-stage interpolator 6. In this case, signal interpolation is performed so that the signals change smoothly. Thus, even if the signals having the sampling frequency 2fs are output, higher harmonics are not generated within the frequency band having a center frequency 1.5fs, as indicated by waveform F of Fig. 22.

Subsequently, the second-stage interpolator 6 performs signal interpolation on the in-phase serial signal and the orthogonal serial signal having a sampling frequency 2fs output from the first-stage interpolator 5, thereby outputting the in-phase serial interpolation signal and the orthogonal serial interpolation signal having a sampling frequency 4fs. The in-phase serial interpolation signal and the orthogonal serial interpolation signal are supplied to the in-phase signal multiplier 7I and the orthogonal signal multiplier 7Q, respectively. In this case, since the second-stage interpolator 6 performs signal interpolation so that the signals change smoothly, higher harmonics are not generated within the frequency range having a center frequency 2.5fs, as indicated by waveform G of Fig. 22, even if the in-phase serial interpolation signal and the orthogonal serial interpolation signal are output with a sampling frequency 4fs four times as high as the sampling frequency fs.

Then, the in-phase signal multiplier 7I multiplies the in-phase serial interpolation signal having the sampling frequency 4fs with the in-phase signal having the sampling frequency fs/2. The orthogonal signal multiplier 7Q multiplies the orthogonal serial interpolation signal having the sampling frequency 4fs with the orthogonal signal having the sampling frequency fs/2. As a consequence, the center frequency of the OFDM modulation signals is shifted by fs/2 to a higher range, and the in-phase serial interpolation signal and the orthogonal serial interpolation signal are output with the sampling frequency 4fs.

Thereafter, the adder 10 adds the in-phase serial interpolation signal and the orthogonal serial interpolation signal, and supplies the resulting signal to the D/A converter 11. The added signal is then converted into an analog signal. As a result, a serial interpolation signal which has an OFDM modulated signal component and which is interpolated with a degree of interpolation of 4 is output from the analog signal output terminal 13.

A description is now given of the process for generating the orthogonal serial interpolation signal by the first IIR digital all-pass filter 5₁, which serves as a 90° phase shifter, the first digital delay unit 5₂, and the first single-pole double-throw switch 5₆ of the first-stage interpolator 5.

As is well known, the orthogonal modulation signal is a signal having a 90° phase delay with respect to the in-phase modulation signal. Accordingly, if the in-phase modulation signal is delayed by 90°, it becomes in phase with the orthogonal modulation signal. Thus, in the tenth embodiment, the in-phase serial signal is delayed by 90° in the first IIR digital all-pass filter 5₁, and also, the orthogonal serial signal is delayed in the first digital delay unit 5₂ by an amount equal to a group delay time generated in the first IIR digital all-pass filter 5₁. As a consequence, the in-phase serial signal becomes in phase with the orthogonal serial signal. In this case, if the first IIR digital all-pass filter 5₁ is configured as described below, the serial signal output from the first IIR digital all-pass filter 5₁ is equal to a signal obtained by time-interpolating the serial signal output from the first digital delay unit 5₂. Thus, the output signal of the first IIR digital all-pass filter 5₁ and the output signal of the first digital delay unit 5₂ are signals having the sampling frequency fs. These signals are supplied to the first single-pole double-throw switch 5₆, and the movable contact of the switch 5₆ is switched with the two-times sampling frequency 2fs, thereby outputting the orthogonal serial interpolation signal interpolated with a degree of interpolation of 2 from the first single-pole double-throw switch 5₆.

A description is now given of the process for generating the in-phase serial interpolation signal by the second IIR digital all-pass filter 5₃, which serves as a 90° phase shifter, the second digital delay unit 5₄, the 180° phase shifter 5₅, and the second single-pole double-throw switch 5₇ of the first-stage interpolator 5.

As is well known, the in-phase modulation signal is a signal having a 90° phase lead or a 270° phase delay with respect to the orthogonal modulation signal. Accordingly, if the in-phase modulation signal is delayed by 270°, it becomes in phase with the orthogonal modulation signal. Thus, in the tenth embodiment, the orthogonal serial signal is delayed by 90° in the second IIR digital all-pass filter 5₃, and is further delayed by 180° in the 180° phase shifter 5₅. As a result, the orthogonal serial signal is delayed by 270°. A 180° phase delay is equal to the inversion of the signal polarity (sign), and thus, the 180° phase shifter 5₅ may be formed by an inverter for inverting the polarity (sign) of the digital signal.

Meanwhile, the in-phase serial signal is delayed by the second digital delay unit 5₄ by an amount equal to a group delay time generated in the second IIR digital all-pass filter 5₃. Thus, the in-phase serial signal becomes in phase with the orthogonal serial signal. In this case, if the second IIR digital all-pass filter 5₃ is configured as described below, the serial signal output from the second IIR digital all-pass filter 5₃ is equal to a signal obtained by time-interpolating the serial signal output from the second digital delay unit 5₄. These signals are supplied to the second single-pole double-throw switch 5₇, and the movable contact of the switch 5₇ is switched with the two-times sampling frequency 2fs, thereby outputting the in-phase serial interpolation signal interpolated with a degree of interpolation of 2 from the second single-pole double-throw switch 5₇.

As described above, the in-phase serial interpolation signal and the orthogonal serial interpolation signal, both of which are interpolated with a degree of interpolation of 2, are output from the first-stage interpolator 5.

The operation of the second-stage interpolator 6 is similar to that of the first-stage interpolator 5, except that the sampling frequency is two times as high as the sampling frequency of the first-stage interpolator 5, and a further explanation thereof is not given.

As described above, according to the OFDM modulation circuit system of the tenth embodiment, signal interpolation is performed with a degree of interpolation of 4 by using the first-stage interpolator 5 including the first and second IIR digital all-pass filters 5₁ and 5₃ and the second-stage interpolator 6 including the first and second IIR digital all-pass filters 6₁ and 6₃. Only four taps are sufficient for the IIR digital all-pass filter 5₁, 5₃, 6₁, or 6₃, and the size of the overall logic circuit can be significantly is less than that of a known OFDM modulation circuit system, thereby achieving a considerable reduction in the power consumption.

In the tenth embodiment, four taps are provided for the IIR digital all-pass filter 5₁, 5₃, 6₁, or 6₃ used in the first-stage interpolator 5 or the second-stage interpolator 6. However, the number of taps is not restricted to four, and a suitable number of taps may be provided according to the phase characteristics required in the IIR digital all-pass filter 5₁, 5₃, 6₁, or 6₃.

For example, if frequency selection characteristics in which the frequency band is 0.05fs to 0.45fs, and the phase ripple in the frequency band is within ±0.5° are required, the number of taps should be changed to five, and the coefficients of the multiplication coefficient generators are set as follows: C₂ = -4.9 × 10⁻¹, C₄ = -1.1 × 10⁻¹, C₆ = -4.0 × 10⁻², C₈ = -1.7 × 10⁻², and C₁₀ = -6.1 × 10⁻³.

If frequency selection characteristics in which the frequency band is a slightly smaller range, i.e., 0.1fs to 0.4fs, and the phase ripple in the frequency band is within ±1.5° are required, the number of taps should be changed to three, and the coefficients of the multiplication coefficient generators are set as follows: C₂ = -4.6 × 10⁻¹, C₄ = -7.1 × 10⁻², and C₆ = -1.3 × 10⁻².

Fig. 23 is a block diagram illustrating an OFDM modulation circuit system according to an eleventh embodiment of the present invention. In the eleventh embodiment, frequency interpolation with a degree of interpolation of 8 is performed by using three interpolators, each having a degree of interpolation of 2.

In the eleventh embodiment, as shown in Fig. 23, a third-stage interpolator 15 is connected between the second-stage interpolator 6 and the orthogonal modulation circuit used in the tenth embodiment, and the oscillation frequency of the local oscillator 8 in the orthogonal modulation circuit is changed to 3fs/2.

In this case, the third-stage interpolator 15 includes a first IIR digital all-pass filter 15₁, which forms a 90° phase shifter (indicated by 90° in Fig. 23), a first digital delay unit 15₂ (indicated by DL in Fig. 23) for supplying a signal having the same amount as the signal delay of the first IIR digital all-pass filter 15₁, a second IIR digital all-pass filter 15₃, which forms a 90° phase shifter (indicated by 90° in Fig. 23), a second digital delay unit 154 (indicated by DL in Fig. 23) for supplying a signal having the same amount as the signal delay of the second IIR digital all-pass filter 15₃, a 180° phase shifter (designated by 180° in Fig. 23) 15₅, a first single-pole double-throw switch 15₆, and a second single-pole double-throw switch 15₇. The connection state of the above-described elements of the third-stage interpolator 15 is the same as that of the second-stage interpolator 6. In Fig. 23, the same elements as those shown in Fig. 21 are designated with like reference numerals.

Fig. 24 illustrates signal waveforms (frequency spectra) obtained in the output circuit of the OFDM modulation circuit system shown in Fig. 23.

The operation of the third-stage interpolator 15 is basically similar to that of the second-stage interpolator 6, except that the sampling frequency is twice as high as the sampling frequency 2fs of the second-stage interpolator 6. That is, the sampling frequency of the third-stage interpolator 15 is 4fs. Upon receiving the in-phase serial signal and the orthogonal serial signal having the sampling frequency 2fs, the third-stage interpolator 15 performs signal interpolation on the in-phase serial signal and the orthogonal serial signal. The resulting in-phase serial interpolation signal and the orthogonal serial interpolation signal having the sampling frequency 4fs are output to the in-phase serial multiplier 7I and the orthogonal signal multiplier 7Q, respectively. In this case, the third-stage interpolator 15 performs signal interpolation so that the signals change smoothly. Thus, even if the signals having the sampling frequency 8fs are output, higher harmonics are not generated within the frequency band having the center frequency 4.5fs, as indicated by waveform I in Fig. 24.

Then, the in-phase signal multiplier 7I multiplies the in-phase serial interpolation signal having the sampling frequency 8fs with the in-phase signal having the sampling frequency 3fs/2. Similarly, the orthogonal signal multiplier 7Q multiplies the orthogonal serial interpolation signal having the sampling frequency 8fs with the orthogonal signal having the sampling frequency 3fs/2. As a result, the center frequency of the OFDM modulation signals is shifted by 3fs/2 to a higher range 2fs, and the in-phase serial interpolation signal and the orthogonal serial interpolation signal are output with the sampling frequency 4fs, as indicated by waveform J in Fig. 24.

The elements other than the third-stage interpolator 15 of the eleventh embodiment are similar to those of the tenth embodiment, and thus, a further explanation thereof is not given. The advantages obtained by the eleventh embodiment are also similar to those achieved by the tenth embodiment, and thus, a further explanation thereof is not given.

Fig. 25 is a block diagram illustrating an OFDM modulation circuit system according to a twelfth embodiment of the present invention. In the twelfth embodiment, frequency interpolation with a degree of interpolation of 2 is performed by using a single interpolator having a degree of interpolation of 2. In Fig. 25, the same elements as those shown in Fig. 21 are indicated by like reference numerals.

In the twelfth embodiment, only the first-stage interpolator 5 is used as interpolation means, and the operation of the first-stage interpolator 5 is basically similar to that of the first-stage interpolator 5 used in the tenth embodiment. More specifically, the in-phase serial signal and the orthogonal serial signal (modulation signal) having the sampling frequency fs are input into the first-stage interpolator 5. The first-stage interpolator 5 then performs signal interpolation on the in-phase serial signal and the orthogonal serial signal. The resulting in-phase serial interpolation signal and the orthogonal serial interpolation signal having the sampling frequency 2fs are output to the in-phase signal multiplier 7I and the orthogonal signal multiplier 7Q, respectively. In this case, the first-stage interpolator 5 performs signal interpolation so that the signals change smoothly. Thus, even if the signals having the sampling frequency 2fs are output, higher harmonics are not generated within the frequency band having the center frequency 1.5fs, as indicated by waveform F in Fig. 22.

Thereafter, the in-phase signal multiplier 7I multiplies the in-phase serial interpolation signal having the sampling frequency 2fs with the in-phase signal having half the sampling frequency fs/2. The orthogonal signal multiplier 7Q multiples the orthogonal serial interpolation signal having the sampling frequency 2fs with the orthogonal signal having half the sampling frequency fs/2. As a result, the center frequency of the OFDM modulation signals is shifted by fs/2 to a higher range fs, and the in-phase serial interpolation signal and the orthogonal serial interpolation signal are output with the sampling frequency 2fs.

The adder 10 adds the in-phase serial interpolation signal and the orthogonal serial interpolation signal. The D/A converter 11 then converts the added serial interpolation signal into an analog signal, and supplies it to the analog signal output terminal 13. As a consequence, the serial interpolation signal which has an OFDM modulated signal component and which is interpolated with a degree of interpolation of 2 is output from the analog signal output terminal 13.

In the tenth, eleventh, and twelfth embodiments, signal interpolation is performed with a degree of interpolation of 4, 8, and 2, respectively. However, the degree of interpolation is not limited to those numbers, and it may be two to the power of N, i.e., 2, 4, 8, 16, and so on, and the number of interpolators is selected according to the degree of interpolation.

## Claims

1. An orthogonal frequency division multiplex modulation circuit system comprising:
inverse fast Fourier transform means for performing an inverse fast Fourier transform operation by mapping a digital modulation signal onto a plurality of sub-carriers whose center frequency is one half a sampling frequency, and for outputting a plurality of inverse fast Fourier transform signals; and
interpolation means for sequentially interpolating according to the type of signal the plurality of inverse fast Fourier transform signals, which are in-phase signals and orthogonal signals, said interpolation means comprising a first-stage interpolator for performing interpolation with a degree of interpolation of 2, and at least one combination of a complex multiplier for shifting frequency spectra to a higher range and a second-stage interpolator for performing interpolation with a degree of interpolation of 2, said combination being cascade-connected to said first-stage interpolator.

2. An orthogonal frequency division multiplex modulation circuit system comprising:
inverse fast Fourier transform means for performing an inverse fast Fourier transform operation by mapping a digital modulation signal onto a plurality of sub-carriers whose center frequency is one half a sampling frequency, and for outputting a plurality of inverse fast Fourier transform signals; and
interpolation means for sequentially interpolating according to the type of signal the plurality of inverse fast Fourier transform signals, which are in-phase signals and orthogonal signals, said interpolation means comprising a first-stage interpolator for performing interpolation with a degree of interpolation of 2, and at least one combination of a complex multiplier for shifting frequency spectra to a higher range and a second-stage interpolator for performing interpolation with a degree of interpolation of 2, said combination being cascade-connected to said first-stage interpolator, and each of said first-stage interpolator and said second-stage interpolator comprising an infinite impulse response digital all-pass filter for shifting one of the in-phase signal and the orthogonal signal by 90 degrees, and a digital delay circuit for delaying the other one of the in-phase signal and the orthogonal signal by an amount equal to a signal delay of said infinite impulse response digital all-pass filter.

3. An orthogonal frequency division multiplex modulation circuit system according to one of claims 1 and 2, wherein said interpolation means comprises said first-stage interpolator and one of said combinations of said complex multiplier and said second-stage interpolator when performing interpolation with a degree of interpolation of 4.

4. An orthogonal frequency division multiplex modulation circuit system according to one of claims 1 and 2, wherein said interpolation means comprises said first-stage interpolator and two of said combinations when performing interpolation with a degree of interpolation of 8.

5. An orthogonal frequency division multiplex modulation circuit system according to one of claims 1 and 2, wherein said interpolation means comprises said first-stage interpolator and three of said combinations when performing interpolation with a degree of interpolation of 16.

6. An orthogonal frequency division multiplex modulation circuit system comprising:
inverse fast Fourier transform means for performing an inverse fast Fourier transform operation by mapping a digital modulation signal onto a plurality of sub-carriers whose center frequency is one half a sampling frequency, and for outputting a plurality of inverse fast Fourier transform signals; and
an interpolator for sequentially interpolating according to the type of signal the plurality of inverse fast Fourier transform signals, which are in-phase signals and orthogonal signals, with a degree of interpolation of 2.

7. An orthogonal frequency division multiplex modulation circuit system comprising:
inverse fast Fourier transform means for performing an inverse fast Fourier transform operation by mapping a digital modulation signal onto a plurality of sub-carriers whose center frequency is one half a sampling frequency, and for outputting a plurality of inverse fast Fourier transform signals; and
an interpolator for sequentially interpolating according to the type of signal the plurality of inverse fast Fourier transform signals, which are in-phase signals and orthogonal signals, said interpolator comprising an infinite impulse response digital all-pass filter for shifting one of the in-phase signal and the orthogonal signal by 90 degrees, and a digital delay circuit for delaying the other one of the in-phase signal and the orthogonal signal by an amount equal to a signal delay of said infinite impulse response digital all-pass filter.

8. An orthogonal frequency division multiplex modulation circuit system according to any one of claims 2 to 5, and 7, wherein said infinite impulse response digital all-pass filter comprises a certain integer, n (n is three or greater), of stages of cascade-connected signal processors, each of said signal processors including a first delay unit, a second delay unit, an adder, a multiplier, and a multiplication coefficient generator, an operating frequency of said signal processor is twice as high as a signal output frequency of said infinite impulse response digital all-pass filter, and constants of said first delay unit, said second delay unit, said adder, said multiplier, and said multiplication coefficient generator are set so that a phase gradient generated in a signal band whose center frequency is one fourth the operating frequency of said signal processor becomes n-1.

9. An orthogonal frequency division multiplex modulation circuit system according to claim 8, wherein said infinite impulse response digital all-pass filter comprises the even-numbered signal processors, counting from an output side of said infinite impulse response digital all-pass filter, so that said signal processors are operated with a frequency one half the operating frequency.

10. An orthogonal frequency division multiplex modulation circuit system comprising:
inverse fast Fourier transform means for performing an inverse fast Fourier transform operation by mapping a digital modulation signal onto a plurality of sub-carriers whose center frequency is one half a sampling frequency, and for outputting a plurality of inverse fast Fourier transform signals; and
interpolation means comprising first-stage interpolation means for sequentially interpolating according to the type of signal the plurality of inverse fast Fourier transform signals, which are in-phase signals and orthogonal signals, and final-stage interpolation means for interpolating one of the in-phase signals and the orthogonal signals, said first-stage interpolation means including a first-stage interpolator for performing interpolation with a degree of interpolation of 2, or said first-stage interpolation means including said first-stage interpolator and at least one combination of a complex multiplier for shifting frequency spectra to a higher range, and a second-stage interpolator for performing interpolation with a degree of interpolation of 2, said combination being cascade-connected to said first-stage interpolator, and said final-stage interpolation means including a complex multiplier for shifting frequency spectra to a higher range and a third-stage interpolator cascade-connected to said complex multiplier so as to perform interpolation with a degree of interpolation of 2.

11. An orthogonal frequency division multiplex modulation circuit system comprising:
inverse fast Fourier transform means for performing an inverse fast Fourier transform operation by mapping a digital modulation signal onto a plurality of sub-carriers whose center frequency is one half a sampling frequency, and for outputting a plurality of inverse fast Fourier transform signals; and
interpolation means comprising first-stage interpolation means for sequentially interpolating according to the type of signal the plurality of inverse fast Fourier transform signals, which are in-phase signals and orthogonal signals, and final-stage interpolation means for interpolating one of the in-phase signals and the orthogonal signals, said first-stage interpolation means including a first-stage interpolator for performing interpolation with a degree of interpolation of 2, or said first-stage interpolation means including said first-stage interpolator and at least one combination of a complex multiplier for shifting frequency spectra to a higher range, and a second-stage interpolator for performing interpolation with a degree of interpolation of 2, said combination being cascade-connected to said first-stage interpolator, said final-stage interpolation means including a complex multiplier for shifting frequency spectra to a higher range and a third-stage interpolator cascade-connected to said complex multiplier so as to perform interpolation with a degree of interpolation of 2, and each of said first-stage interpolator, said second-stage interpolator, and said third-stage interpolator including an infinite impulse response digital all-pass filter for shifting one of the in-phase signals and the orthogonal signals by 90 degrees, and a digital delay circuit for delaying the other one of the in-phase signals and the orthogonal signals by an amount equal to a signal delay of said infinite impulse response digital all-pass filter.

12. An orthogonal frequency division multiplex modulation circuit system according to one of claims 10 and 11, wherein said interpolation means comprises said first-stage interpolation means which includes only the first-stage interpolator and said final-stage interpolation means when performing interpolation with a degree of interpolation of 4.

13. An orthogonal frequency division multiplex modulation circuit system according to one of claims 10 and 11, wherein said interpolation means comprises said first-stage interpolation means which includes said first-stage interpolator and one of said combinations and said final-stage interpolation means when performing interpolation with a degree of interpolation of 8.

14. An orthogonal frequency division multiplex modulation circuit system according to one of claims 10 and 11, wherein said interpolation means comprises said first-stage interpolation means which includes said first-stage interpolator and two of said combinations and said final-stage interpolation means when performing interpolation with a degree of interpolation of 16.

15. An orthogonal frequency division multiplex modulation circuit system comprising:
inverse fast Fourier transform means for performing an inverse fast Fourier transform operation by mapping a digital modulation signal onto a plurality of sub-carriers whose center frequency is one half a sampling frequency, and for outputting a plurality of inverse fast Fourier transform signals; and
interpolation means comprising a single interpolator for interpolating the plurality of inverse fast Fourier transform signals, which are in-phase signals, or the plurality of inverse fast Fourier transform signals, which are orthogonal signals, with a degree of interpolation of 2.

16. An orthogonal frequency division multiplex modulation circuit system comprising:
inverse fast Fourier transform means for performing an inverse fast Fourier transform operation by mapping a digital modulation signal onto a plurality of sub-carriers whose center frequency is one half a sampling frequency, and for outputting a plurality of inverse fast Fourier transform signals; and
interpolation means comprising a single interpolator for interpolating the plurality of inverse fast Fourier transform signals, which are in-phase signals, or the plurality of inverse fast Fourier transform signals, which are orthogonal signals, with a degree of interpolation of 2, and said interpolator including an infinite impulse response digital all-pass filter for shifting one of the in-phase signals and the orthogonal signals by 90 degrees, and a digital delay circuit for delaying the other one of the in-phase signals and the orthogonal signals by an amount equal to a signal delay of said infinite impulse response digital all-pass filter.

17. An orthogonal frequency division multiplex modulation circuit system according to any one of claims 11 to 14, and 16, wherein said infinite impulse response digital all-pass filter comprises a certain integer, n (n is three or greater), of stages of cascade-connected signal processors, each of said signal processors including a first delay unit, a second delay unit, an adder, a multiplier, and a multiplication coefficient generator, an operating frequency of said signal processor is twice as high as a signal output frequency of said infinite impulse response digital all-pass filter, and constants of said first delay unit, said second delay unit, said adder, said multiplier, and said multiplication coefficient generator are set so that a phase gradient generated in a signal band whose center frequency is one fourth the operating frequency of said signal processor becomes n-1.

18. An orthogonal frequency division multiplex modulation circuit system according to claim 17, wherein said infinite impulse response digital all-pass filter comprises the even-numbered signal processors, counting from an output side of said infinite impulse response digital all-pass filter, so that said signal processors are operated with a frequency one half the operating frequency.

19. An orthogonal frequency division multiplex modulation circuit system comprising:
inverse fast Fourier transform means for performing an inverse fast Fourier transform operation by mapping a digital modulation signal onto a plurality of sub-carriers whose center frequency is one half a sampling frequency, and for outputting a plurality of inverse fast Fourier transform signals;
interpolation means comprising one interpolator or a plurality of cascade-connected interpolators for sequentially interpolating according to the type of signal the plurality of inverse fast Fourier transform signals, which are in-phase signals and orthogonal signals, with a degree of interpolation of 2; and
orthogonal modulation means for orthogonal-modulating the in-phase interpolation signals and the orthogonal interpolation signals output from said interpolation means.

20. An orthogonal frequency division multiplex modulation circuit system comprising:
inverse fast Fourier transform means for performing an inverse fast Fourier transform operation by mapping a digital modulation signal onto a plurality of sub-carriers whose center frequency is one half a sampling frequency, and for outputting a plurality of inverse fast Fourier transform signals;
interpolation means comprising one interpolator or a plurality of cascade-connected interpolators for sequentially interpolating according to the type of signal the plurality of inverse fast Fourier transform signals, which are in-phase signals and orthogonal signals, with a degree of interpolation of 2; and
orthogonal modulation means for orthogonal-modulating the in-phase interpolation signals and the orthogonal interpolation signals output from said interpolation means,
wherein said interpolator includes an infinite impulse response digital all-pass filter for shifting one of the in-phase signals and the orthogonal signals by 90 degrees, and a digital delay circuit for delaying the other one of the in-phase signals and the orthogonal signals by an amount equal to a signal delay of said infinite impulse response digital all-pass filter.

21. An orthogonal frequency division multiplex modulation circuit system according to one of claims 19 and 20, wherein said interpolation means comprises two of said interpolators when performing interpolation with a degree of interpolation of 4.

22. An orthogonal frequency division multiplex modulation circuit system according to one of claims 19 and 20, wherein said interpolation means comprises three of said interpolators when performing interpolation with a degree of interpolation of 8.

23. An orthogonal frequency division multiplex modulation circuit system according to one of claims 19 and 20, wherein said interpolation means comprises four of said interpolators when performing interpolation with a degree of interpolation of 16.

24. An orthogonal frequency division multiplex modulation circuit system according to any one of claims 20 to 23, wherein said infinite impulse response digital all-pass filter comprises a certain integer, n (n is three or greater), of stages of cascade-connected signal processors, each of said signal processors including a first delay unit, a second delay unit, an adder, a multiplier, and a multiplication coefficient generator, an operating frequency of said signal processor is twice as high as a signal output frequency of said infinite impulse response digital all-pass filter, and constants of said first delay unit, said second delay unit, said adder, said multiplier, and said multiplication coefficient generator are set so that a phase gradient generated in a signal band whose center frequency is one fourth the operating frequency of said signal processor becomes n-1.

25. An orthogonal frequency division multiplex modulation circuit system according to claim 24, wherein said infinite impulse response digital all-pass filter comprises the even-numbered signal processors, counting from an output side of said infinite impulse response digital all-pass filter, so that said signal processors are operated with a frequency one half the operating frequency.
